# EUROPEAN PATENT SPECIFICATION

(11) **EP 2 472 580 B1**
(45) Date of publication and mention of the grant of the patent: **03.08.2016**
(21) Application number: 11006759.2
(22) Date of filing: 18.08.2011
(51) Int. Cl.: H01L 27/146, H04N 5/369

(54) **Method for making a curved sensor**
Herstellungsverfahren für einen gekrümmten Sensor
Procédé de fabrication d'un capteur incurvé

(30) Priority: 28.12.2010 US 930165; 21.03.2011 US 201113065477; 30.06.2011 US 201113135402
(43) Date of publication of application: 04.07.2012
(73) Proprietor: Sutton, Gary Edwin, La Jolla, CA 92037 (US)
(72) Inventor: Sutton, Gary Edwin, La Jolla, CA 92037 (US)
(74) Representative: Prinz & Partner mbB

(56) References cited:
- EP-A2- 0 973 122
- EP-A2- 2 088 572
- WO-A1-2010/094929
- WO-A2-2007/146129
- US-A1- 2004 095 492
- US-A1- 2008 151 089

## Description

The present invention relates to a method of forming a curved image sensor.

Current photographic cameras evolved from the first "box" and "bellows" models into three basic formats by the late twentieth century.

The rangefinder came first. It was followed by the SLR, or, single lens reflex and finally the Compact "Point and Shoot" cameras. Most portable cameras today use rangefinder, SLR or "Point and Shoot" formats.

### Simple Conventional Cameras

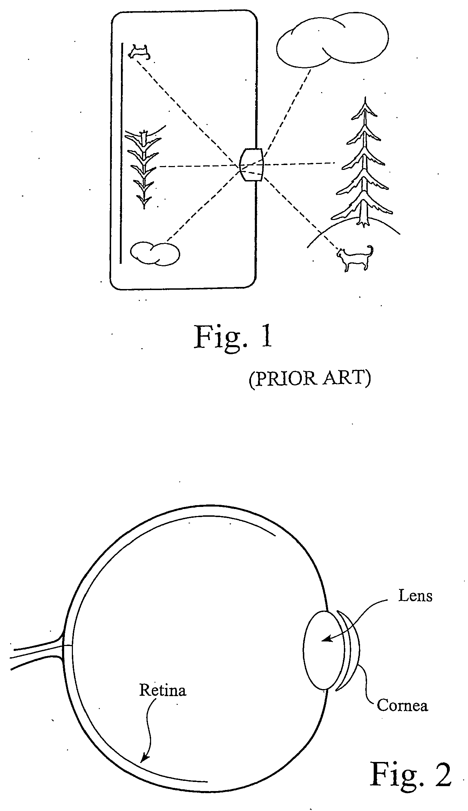

Figure 1 is a simplified view of a conventional camera, which includes an enclosure, an objective lens and a flat section of photographic film or a flat sensor. A simple lens with a flat film or sensor faces several problems. Light travels over a longer pathway to the edges of the film or the sensor's image area, diluting those rays. Besides being weaker, as those rays travel farther to the sensor's edges, they suffer more "rainbow effect," or chromatic aberration.

Figure 2 presents a simplified view of the human eye, which includes a curved surface for forming an image. The human eye, for example, needs only a cornea and a single lens to form an image. But on average, one human retina contains twenty-five million rods and six million cones. Today's high end cameras use lenses with from six to twenty elements. Only the rarest, most expensive cameras have as many pixels as the eye has rods and cones, and none of these cameras capture images after sunset without artificial light.

The eagle's retina has eight times as many retinal sensors as the human eye. They are arranged on a sphere the size of a marble. The eagle's rounded sensors make simpler optics possible. No commercially available camera that is available today has a pixel count which equals a fourth of the count of sensors in an eagle's eye. The eagle eye uses a simple lens and a curved retina. The best conventional cameras use multiple element lenses with sophisticated coatings, rare earth materials and complex formulas. This is all to compensate for their flat sensors. The eagle sees clearly at noon, in daylight or at dusk with simpler, lighter and smaller optics than any camera.

### Rangefinder Cameras

Rangefinder cameras are typified by a broad spectrum from the early LEICA™thirty-five millimeter cameras, for professionals, to the later "INSTAMATIC™" film types for the masses.

Rangefinder cameras have a "taking" lens to put the image on the film (or sensor today) when the shutter opens and closes; mechanically or digitally. These cameras use a second lens for viewing the scene. Focusing takes place through this viewing lens which connects to, and focuses, the taking lens.

Since the taking lens and the viewing lens are different, and have different perspectives on the scene being photographed, the taken image is always slightly different than the viewed image. This problem, called parallax, is minor in most situations but becomes acute at close distances.

Longer telephoto lenses, which magnify more, are impractical for rangefinder formats. This is because two lenses are required, they are expensive and require more side-to-side space than exists within the camera body. That's why no long telephoto lenses exist for rangefinder cameras.

### Compact, or "Point and Shoot" Cameras

Currently, the most popular format for casual photographers is the "Point and Shoot" camera. They emerged first as film cameras but are now nearly all digital. Many have optical zoom lenses permanently attached with no possibility for interchanging optics. The optical zoom, typically, has a four to one range, going from slight wide angle to mild telephoto perspectives. Optical zooms don't often go much beyond this range for acceptable results and speed. Some makers push optical zoom beyond this four to one range, but the resulting images and speeds deteriorate. Others add digital zoom to enhance their optical range; causing results that most trade editors and photographers currently hate, for reasons described in the following.

There are no "Point and Shoot" cameras with wide angle lenses as wide as the perspective are for an eighteen millimeter SLR lens (when used, for relative comparison, on the old standard thirty-five millimeter film SLR cameras.) There are no "Point and Shoot" cameras with telephoto lenses as long as a two hundred millimeter SLR lens would have been (if on the same old thirty-five millimeter film camera format.)

Today, more photographs are taken daily by mobile phones and PDAs than by conventional cameras. These will be included in the references herein as "Point and Shoot Cameras."

### Single Lens Reflex (SLR) Cameras

Single lens reflex cameras are most commonly used by serious amateurs and professionals today since they can use wide selections of accessory lenses.

With 35 mm film SLRs, these lenses range from 18 mm "fisheye" lenses to 1,000 mm super-telephoto lenses, plus optical zooms that cover many ranges in between.

With SLRs there's a mirror behind the taking lens which reflects the image into a viewfinder. When the shutter is pressed, this mirror flips up and out of the way, so the image then goes directly onto the film or sensor. In this way, the viewfinder shows the photographer almost the exact image that will be taken, from extremes in wide vistas to distant telephoto shots. The only exception to an "exact" image capture comes in fast action photography, when the delay caused by the mirror movement can result in the picture taken being slightly different than that image the photographer saw a fraction of a second earlier.

This ability to work with a large variety of lenses made the SLR a popular camera format of the late twentieth century, despite some inherent disadvantages.

Those SLR disadvantages are the complexity of the mechanism, requiring more moving parts than with other formats, plus the noise, vibration and delay caused by the mirror motion. Also, lens designs are constrained, due to the lens needing to be placed farther out in front of the path of the moving mirror, which is more distant from the film or sensor, causing lenses to be heavier, larger and less optimal. There is also the introduction of dust, humidity and other foreign objects into the camera body and on the rear lens elements when lenses are changed.

### Optical Zoom Lenses

Optical zoom lenses reduce the need to change lenses with an SLR. The photographer simply zooms in or out. Still, for some situations, an even wider or longer accessory lens is required with the SLR, and the photographer changes lenses anyway.

Many "Point and Shoot" cameras today have zoom lenses as standard; permanently attached. Nearly all SLRs offer zoom lenses as accessories. While optical technology continues to improve, there are challenges to the zoom range any lens can adequately perform. Other dilemmas with zoom lenses are that they are heavier than their standard counterparts, they are "slower," meaning less light gets through, limiting usefulness, and zoom lenses never deliver images that are as sharp or deliver the color fidelity as a comparable fixed focal length lens. And again, the optical zoom, by moving more elements in the lens, introduces more moving parts, which can lead to mechanical problems with time and usage, plus added cost. Because optical zooms expand mechanically, they also function like an air pump, sucking in outside air while zooming to telephoto and squeezing out air when retracting for wider angle perspectives. This can introduce humidity and dust to the inner elements.

### The Limitations of Conventional Mobile Phone Cameras

The Gartner Group reported that over one billion mobile phones were sold worldwide in 2009. A large portion of currently available mobile phones include a camera. These cameras are usually low quality photographic devices with simple planar arrays situated behind a conventional lens. The quality of images that may be captured with these cell phone cameras is generally lower than that which may be captured with dedicated point-and-shoot or more advanced cameras. Cell phone cameras usually lack advanced controls for shutter speed, telephoto or other features.

Conventional cell phone and PDA cameras suffer from the same four deficiencies.
1. Because they use flat digital sensors, the optics are deficient, producing poor quality pictures. To get normal resolution would require larger and bulkier lenses, which would cause these compact devices to become unwieldy.
2. Another compromise is that these lenses are slow, gathering less light. Many of the pictures taken with these devices are after sunset or indoors. This often means flash is required to enhance the illumination. With the lens so close to the flash unit, as is required in a compact device, a phenomena known as "red-eye" often occurs. In darkened situations, the pupil dilates in order to see better. In that situation, the flash often reflects off the subject's retina, creating a disturbing "red eye" image.
3. Flash photography shortens battery life.
4. Flash photography is artificial. Faces in the foreground can be bleached white while backgrounds go dark. Chin lines are pronounced, and it sometimes becomes possible to see into a human subject's nostrils, which is not always pleasing to viewers.

Current sales of high definition television sets demonstrate the growing public demand for sharper images. In the past, INSTAMATIC® cameras encouraged more picture-taking, but those new photographers soon tired of the relatively poor image quality. Thirty-five millimeter cameras, which were previously owned mostly by professionals and serious hobbyists, soon became a mass market product.

With unprecedented numbers of photos now being taken with mobile phones, and the image quality being acceptable now, but probably less acceptable in the near future, this cycle is likely to repeat.

The development of a system that reduces these problems would constitute a major technological advance, and would satisfy long-felt needs in the imaging business.

WO2010/094929 A1 discloses a sensor system for digital cameras comprising a non-planar sensor. The sensor comprises a plurality of facets placed in an array to form a curvilinear configuration, where the facets in the central region have a greater pixel density than those near the edge of the array. In a camera enclosure, the curved sensor is arranged and aligned with respect to an objective lens to collect incoming radiation. The apparatus employing the curved sensor may be a cellular phone camera.

### SUMMARY OF THE INVENTION

The present invention provides a method for forming a curved sensor as defined in claim 1.

Further embodiments are disclosed in the dependent claims.

### A BRIEF DESCRIPTION OF THE DRAWINGS

- Figure 1 depicts a generalized conventional camera with flat film or a flat sensor.
- Figure 2 is a simplified depiction of the human eye.
- Figure 3 provides a generalized schematic diagram of a digital camera with a curved sensor manufactured in accordance with one embodiment of the present invention.
- Figures 4A, 4B, and 4C offer an assortment of views of a generally curved sensor.
- Figure 5 depicts a sensor formed from nine planar segments or facets.
- Figure 6 reveals a cross-sectional view of a generally curved surface comprising a number of flat facets.
- Figure 7 provides a perspective view of the curved surface shown in Figure 6.
- Figure 8 offers a view of one method of making the electrical connections for the sensor shown in Figures 6 and 7.
- Figures 9A and 9B portray additional details of the sensor illustrated in Figure 7, before and after enlarging the gaps above the substrate, so the flat surface can be bent.
- Figures 10A and 10B supply views of sensor connections.
- Figures 11A and 11B depict a series of petal-shaped segments of ultra-thin silicon that are bent or otherwise formed to create a generally dome-shaped surface, somewhat like an umbrella.
- Figure 12 furnishes a detailed view of an array of sensor segments.
- Figure 13 is a perspective view of a curved shape that is produced when the segments shown in Figure 12 are joined.
- Figures 14A, 14B and 14C illustrate an alternative method that uses a thin layer of semiconductor material that is formed into a generally dome-shaped surface using a mandrel.
- Figures 14D, 14E and 14F illustrate methods for formed a generally dome-shaped surface using a mandrel.
- Figure 14G shows the dome-shaped surface after sensors have been deployed on its surface.
- Figure 15A shows a camera taking a wide angle photo image.
- Figure 15B shows a camera taking a normal perspective photo image.
- Figure 15C shows a camera taking a telephoto image.
- Figures 16 and 17 illustrate the feature of variable pixel density by comparing views of a conventional sensor with an example being useful to understand the present invention, where pixels are more concentrated in the center.
- Figures 18, 19, 20 and 21 provide schematic views of a camera with a retractable and extendable shade. When the camera is used for wide angle shots, the lens shade retracts. For telephoto shots, the lens shade extends. For normal perspectives, the lens shade protrudes partially.
- Figures 22 and 23 supply two views of a composite sensor. In the first view, the sensor is aligned in its original position, and captures a first image. In the second view, the sensor has been rotated, and captures a second image. The two successive images are combined to produce a comprehensive final image.
- Figures 24A and 24B offer an alternative example to that shown in Figures 22 and 23, in which the sensor position is displaced diagonally between exposures.
- Figures 25A, 25B, 25C and 25D offer four views of sensors that include gaps between a variety of arrays of sensor facets.
- Figures 26, 27 and 28 provide illustrations of the back of a moving sensor, revealing a variety of connecting devices which may be used to extract an electrical signal.
- Figure 29 is a block diagram that illustrates a wireless connection between a sensor and a processor.
- Figure 30 is a schematic side sectional view of a camera apparatus in accordance with another example being useful to understand the present invention.
- Figure 31 is a front view of the sensor of the camera apparatus of Fig. 30.
- Figure 32 is a block diagram of a camera apparatus in accordance with a further example being useful to understand the present invention.
- Figures 33, 34, 35, 36 and 37 provide various views of an electronic device which incorporates a curved sensor.
- Figures 38 through 50 illustrate a method to capture more detail from a scene than the sensor is otherwise capable of recording.
- Figure 51 presents a schematic illustration of an optical element which moves in a tight circular path over a stationary flat sensor.
- Figure 52 is an overhead view of the optical element and sensor shown in Figure 51.
- Figure 53 presents a schematic illustration of an optical element which moves over a stationary curved sensor.
- Figure 54 is an overhead view of the optical element and sensor shown in Figure 53.
- Figure 55 presents a schematic illustration of a method for imparting motion to a flat sensor, which moves beneath a stationary optical element.
- Figure 56 is an overhead view of the optical element and sensor shown in Figure 55.
- Figure 57 presents a schematic illustration of a method for imparting circular motion to a sensor, such as the ones shown in Figures 55 and 56.
- Figure 58 is a perspective illustration of the components shown in Figure 58.
- Figure 59 presents a schematic illustration of a method for imparting motion to a curved sensor, which moves beneath a stationary optical element.
- Figure 60 is an overhead view of the optical element and sensor shown in Figure 59.
- Figure 61 is a schematic illustration of a method for imparting circular motion to an optical element.
- Figure 62 presents nine sequential views of a flat sensor as it moves in a single circular path.
- Figure 63 is a schematic representation of a flat sensor arrayed with pixels. In Figure 63, the sensor resides in its original position. In Figures 64 and 65, the sensor continues to rotate through the circular path.
- Figure 66 depicts a single strand of silicon fiber.
- Figure 67 shows a mesh woven from silicon fibers.
- Figures 68 and 69 illustrate a method for forming a dome of woven fabric using a pair of heated mandrels.
- Figures 70 and 71 depict a method for arranging parallel fibers and then heating them to form a fused laminate that includes a hemispherical portion.
- Figure 72 illustrates a method for arranging two sets of orthogonal fibers and heating them to form a fused laminate.
- Figure 73 supplies a view of a curved sensor having different sized mini-sensors.
- Figure 74 shows the sensor depicted in Figure 73 as it rotates.
- Figure 75 shows a section of staggered pixel arrays.

### DETAILED DESCRIPTION OF PREFERRED EMBODIMENTS

### I. Overview of the Invention

The present invention provides a method for forming a curved sensor. The present invention may be incorporated in a mobile communication device. In this Specification, and in the Claims that follow, the terms "mobile communication device" and "mobile communication means" are intended to include any apparatus or combination of hardware and/or software which may be used to communicate, which includes transmitting and/or receiving information, data or content or any other form of signals or intelligence.

Specific examples of mobile communication devices include cellular or wireless telephones, smart phones, personal digital assistants, laptop or netbook computers, iPads™ or other readers/computers, or any other generally portable device which may be used for telecommunications or viewing or recording visual content.

Unlike conventional cellular telephones which include cameras that utilize conventional flat sensors, the present invention includes curved or otherwise non-planar sensors. In one embodiment, the non-planar surfaces of the sensor used in the present invention comprise a plurality of small flat segments which altogether approximate a curved surface. In general, the sensor used by the present invention occupies three dimensions of space, as opposed to conventional sensors, which are planes that are substantially and generally contained in two physical dimensions.

The present invention may utilize sensors which are configured in a variety of three-dimensional shapes, including, but not limited to, spherical, paraboloidal and ellipsoidal surfaces.

In the present Specification, the terms "curvilinear" and "curved" encompass any line, edge, boundary, segment, surface or feature that is not completely colinear with a straight line. The term "sensor" encompasses any detector, imaging device, measurement device, transducer, focal plane array, charge-coupled device (CCD), complementary metal-oxide semiconductor (CMOS) or photocell that responds to an incident photon of any wavelength.

While the embodiments of the present invention and the examples are configured to record images in the optical spectrum, other examples and embodiments of the present invention may be used for a variety of tasks which pertain to gathering, sensing and/or recording other forms of radiation. Examples and embodiments of the present invention include systems that gather and/or record color, black and white, infra-red, ultraviolet, x-rays or any other stream of radiation, emanation, wave or particle. Examples and embodiments of the present invention also include systems that record still images or motion pictures.

### II. Specific Examples of the Invention

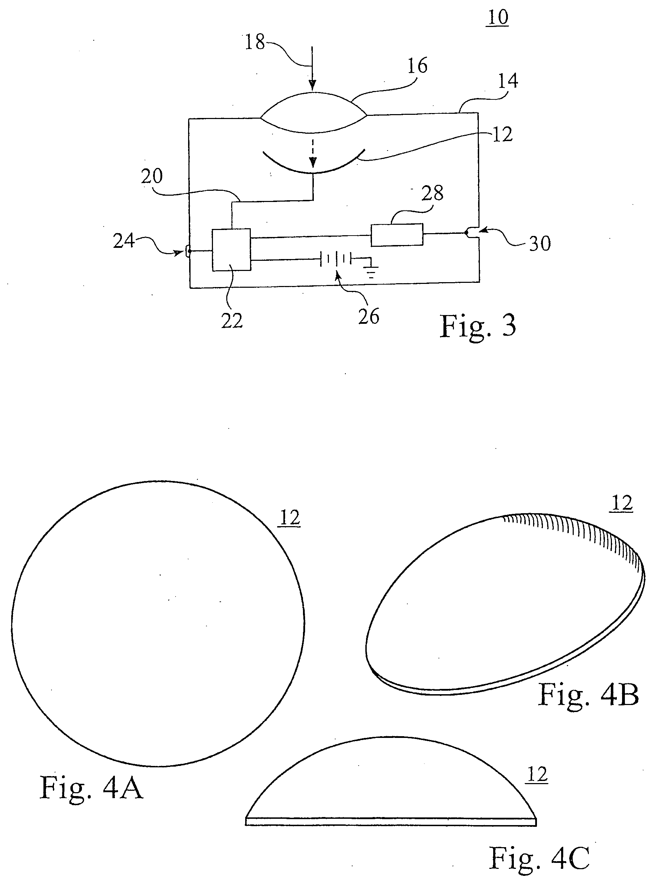

Figure 3 provides a generalized schematic diagram of a digital camera 10 with a curved sensor 12 sub-assembly which may be incorporated into a mobile communication device. A housing 14 has an optical element 16 mounted on one of its walls. The objective lens 16 receives incoming light 18. In this example, the optical element is an objective lens. In general, the sensor 12 converts the energy of the incoming photons 18 to an electrical output 20, which is then fed to a signal or photon processor 22. The signal processor 22 is connected to user controls 24, a battery or power supply 26 and to a solid state memory 28. Images created by the signal processor 22 are stored in the memory 28. Images may be extracted or downloaded from the camera through an output terminal 30, such as a USB port.

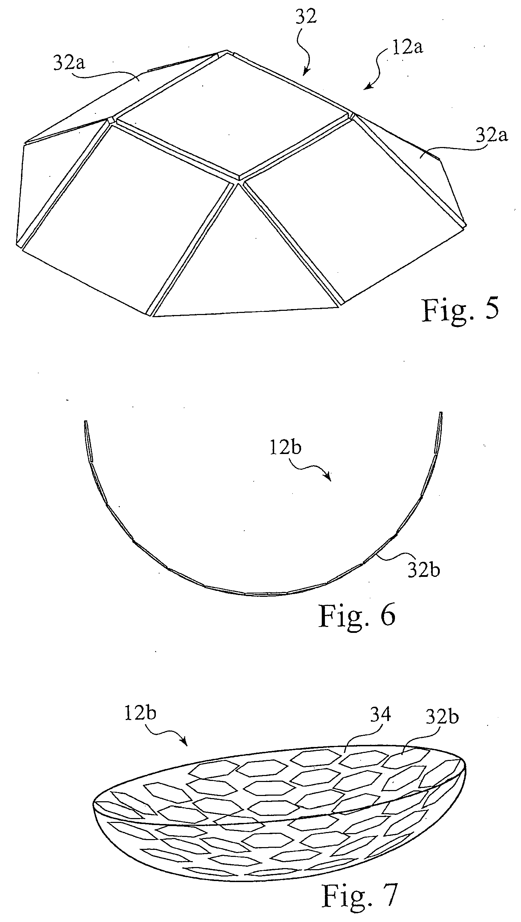

Examples being useful to understand the present invention include, but are not limited to, mobile communication devices with a camera that incorporate the following sensors:
1. Curved sensors: Generally continuous portions of spheres, or revolutions of conic sections such as parabolas or ellipses or other non-planar shapes. Examples of a generally curved sensor 12 appear in Figures 4A, 4B and 4C. In this specification, various examples of curved sensors are identified with reference character 12, 12a, 12b, 12c, and so on.
2. Faceted sensors: Aggregations of polygonal facets or segments. Any suitable polygon may be used, including squares, rectangles, triangles, trapezoids, pentagons, hexagons, septagons, octagons or others. Figure 5 exhibits a sensor 12a comprising nine flat polygonal segments or facets 32a. For some applications, a simplified assembly of a few flat sensors might lose most of the benefit of a smoother curve, while achieving a much lower cost. Figures 6 and 7 provide side and perspective views of a generally spherical sensor surface 12b comprising a number of flat facets 32b. Figure 7 shows exaggerated gaps 34 between the facets. The facets could each have hundreds, thousands or many millions of pixels. In this specification, the facets of the sensor 12 are identified with reference characters 32, 32a, 32b, 32c and so on.

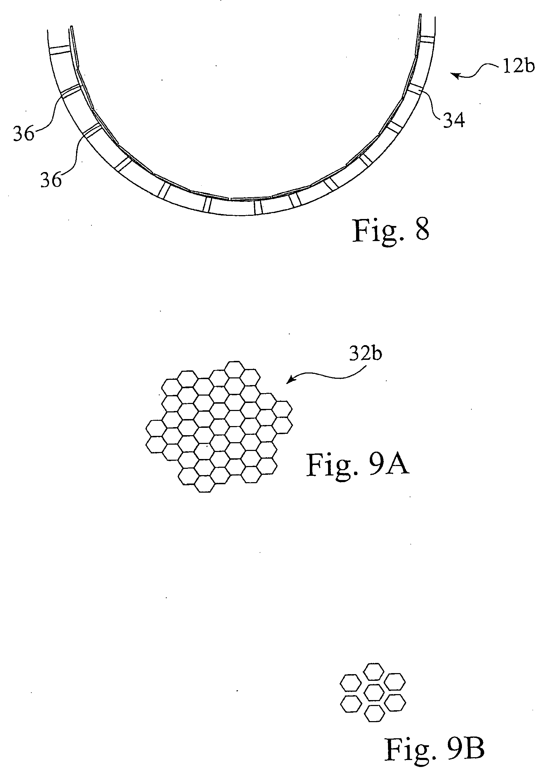

Figure 8 offers a view of the electrical connections 36 for the curved sensor 12b shown in Figure 7. The semiconductor facet array is disposed on the interior surface. The exterior surface may be a MYLAR™, KAPTON™ or similar wiring backplane formed in a curved shape. Vias provide electrical connections between the facet array and the wiring backplane. In one embodiment, two to two thousand or more electrical pathways may connect the facet array and the wiring backplane.

Figure 9 provides a detailed view of facets on the curved sensor 12b. In general, the more polygons that are employed to mimic a generally spherical surface, the more the sensor will resemble a smooth curve. In one embodiment of the invention, a wafer is manufactured so that each camera sensor has tessellated facets. Either the front side or the rear side of the wafer of sensor chips is attached to a flexible membrane that may bend slightly (such as MYLAR™ or KAPTON™), but which is sufficiently rigid to maintain the individual facets in their respective locations. A thin line is etched into the silicon chip between each facet, but not through the flexible membrane. The wafer is then shaped into a generally spherical surface. Each facet is manufactured with vias formed through the wafer to connect a rear wiring harness. This harness may also provide mechanical support for the individual facets.

Figures 9A and 9B furnish a view of the facets 32b which reside on the interior of the curved sensor, and the electrical interconnects that link the sensor facets with the wiring backplane.

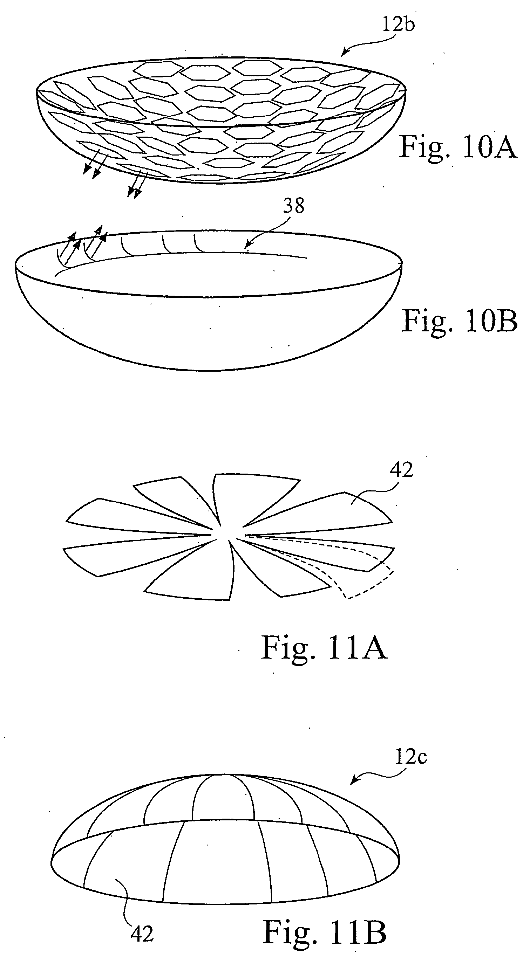

Figures 10A and 10B illustrate a wiring backplane 38 which may be used to draw output signals from the facets on the sensor.

Figures 11A and 11B show a generally hemispherical shape 40 that has been formed by bending and then joining a number of ultra-thin silicon petal-shaped segments 42. These segments are bent slightly, and then joined to form the curved sensor.

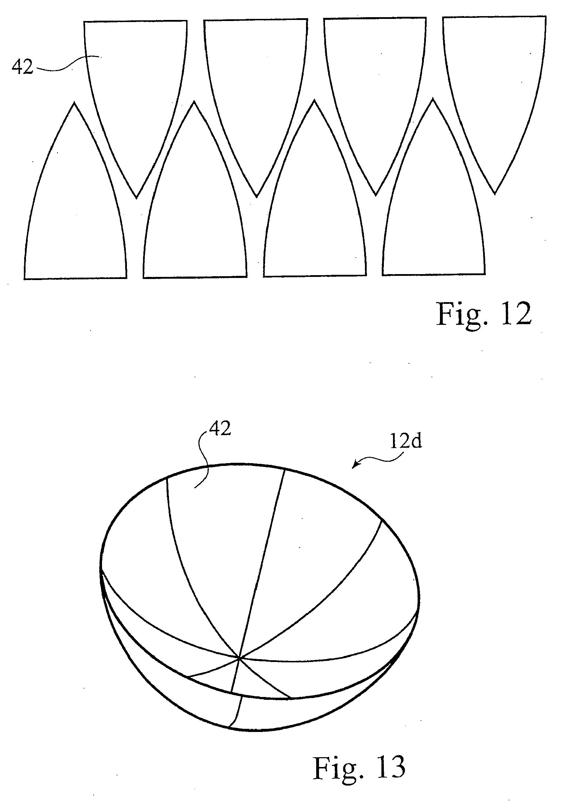

Figure 12 provides a view of one example of the petal-shaped segments 42. Conventional manufacturing methods may be employed to produce these segments. In one example, these segments are formed from ultra-thin silicon, which are able to bend somewhat without breaking. In this Specification, and in the Claims that follow, the term "ultra-thin" denotes a range extending generally from 50 to 250 microns. In another embodiment, pixel density is increased at the points of the segments, and are gradually decreased toward the base of each segment. This example may be implemented by programming changes to the software or mask that creates the pixels.

Figure 13 offers a perspective view of one example of a curved shape that is formed when the segments shown in Figure 12 are joined or slightly overlap. The sensors are placed on the concave side, while the electrical connections are made on the convex side. The number of petals used to form this non-planar surface may comprise any suitable number. Heat or radiation may be employed to form the silicon into a desired shape. The curvature of the petals may be varied to suit any particular sensor design.

In one alternative example, a flat center sensor might be surrounded by these "petals" with squared-off points.

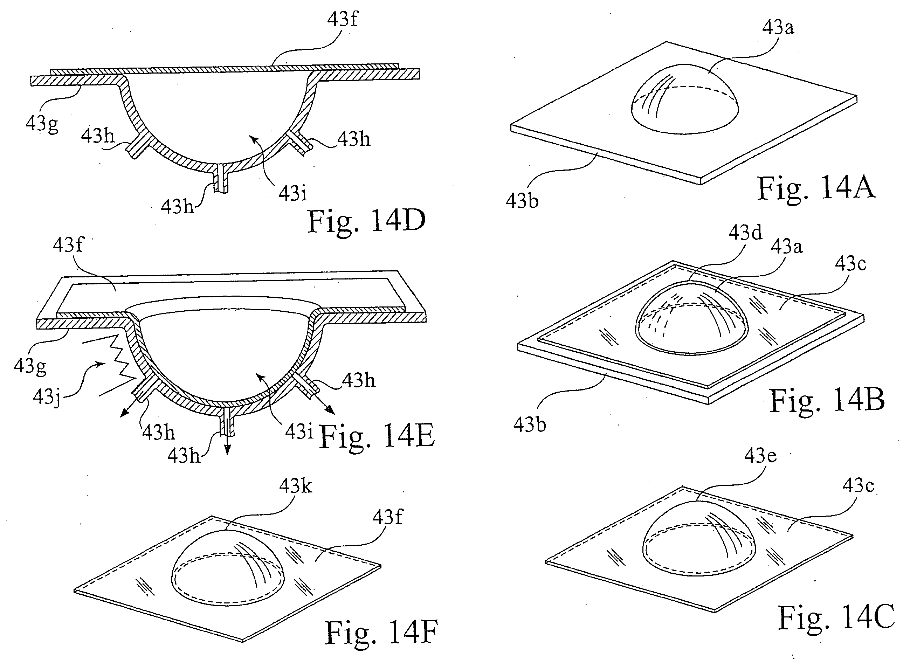

Figures 14A, 14B and 14C depict an alternative method for forming a curved sensor. Figure 14A depicts a dome-shaped first mandrel 43a on a substrate 43b. In Figure 14B, a thin sheet of heated deformable material 43c is impressed over the first mandrel 43a. The central area of the deformable material 43c takes the shape of the first mandrel 43a, forming a generally hemispherical base 43e for a curved sensor, as shown in Figure 14C.

Figures 14D, 14E and 14F depict an alternative method for forming the base of a curved sensor. In Figure 14D, a second sheet of heated, deformable material 43f is placed over a second mandrel 43g. A vacuum pressure is applied to ports 43h, which draws the second sheet of heated, deformable material 43f downward into the empty region 43i enclosed by the second mandrel 43g. Figure 14E illustrates the next step in the process. A heater 43j increases the temperature of the second mandrel 43g, while the vacuum pressure imposed on ports 43h pulls the second sheet of heated, deformable material 43f down against the inside of the second mandrel 43g. Figure 14F shows the resulting generally hemispherical dome 43k, which is then used as the base of a curved sensor.

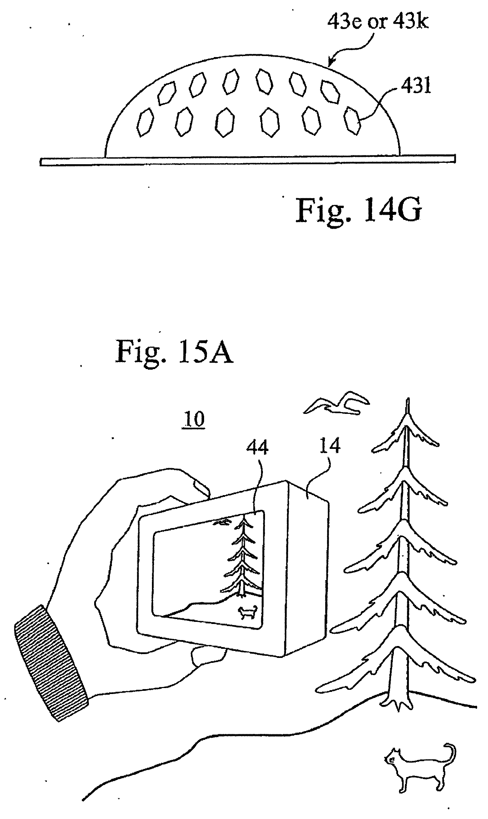

Figure 14G shows a generally hemispherical base 43e or 43k for a curved sensor after sensor pixels 43I have been formed on the base 43e or 43k.

### Digital Zoom Enhancements

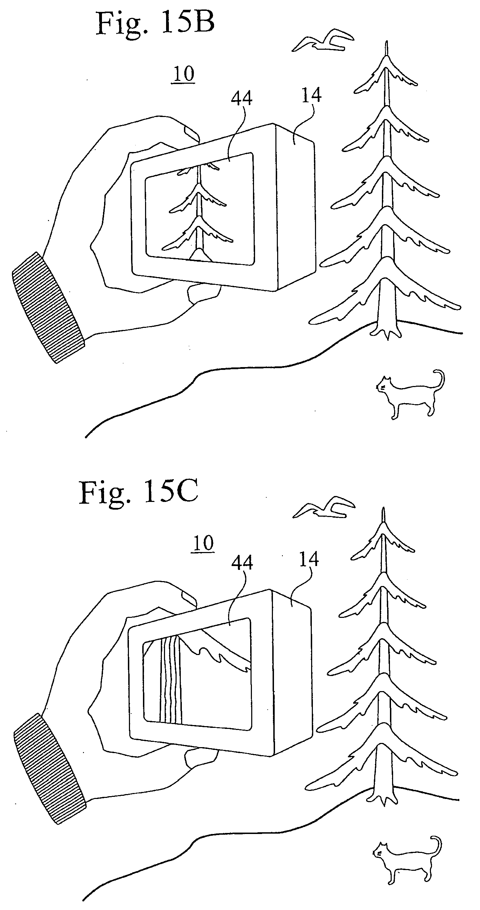

Figure 15A shows a camera taking a wide angle photo. Figure 15A shows the same camera taking a normal perspective photo, while Figure 15B shows a telephoto view. In each view, the scene stays the same. The view screen on the camera shows a panorama in Figure 15A, a normal view in Figure 15B, and detail from the distance in Figure 15C. Just as with optical zoom, digital zoom shows the operator exactly the scene that is being processed from the camera sensor.

Digital zoom is software-driven. The camera either captures only a small portion of the central image, the entire scene or any perspective in between. The monitor shows the operator what portion of the overall image is being recorded. When digitally zooming out to telephoto in one example, which uses denser pixels in its center, the software can use all the data. Since the center has more pixels per area, the telephoto image, even though it is cropped down to a small section of the sensor, produces a crisp image. This is because the pixels are more dense at the center.

When the camera has "zoomed back" into a wide angle perspective, the software can compress the data in the center to approximate the density of the pixels in the edges of the image. Because so many more pixels are involved in the center of this wide angle scene, this does not effect wide angle image quality. Yet, if uncompressed, the center pixels represent unnecessary and invisible detail captured, and require more storage capacity and processing time. Current photographic language might call the center section as being processed "RAW" or uncompressed when shooting telephoto but being processed as "JPEG" or other compression algorithm in the center when the image is wide angle.

Digital zoom is currently disdained by industry experts. When traditional sensors capture an image, digital zooming creates images that break up into jagged lines, forms visible pixels and yields poor resolution.

Optical zoom has never created images as sharp as fixed focus length lenses are capable of producing. Optical zooms are also slower, letting less light through the optical train.

The examples provide lighter, faster, cheaper and more dependable cameras. One example provides digital zoom. Since this does not require optical zoom, it uses inherently lighter lens designs with fewer elements.

In various examples and embodiments of the invention, more pixels are concentrated in the center of the sensor, and fewer are placed at the edges of the sensor. Various densities may be arranged in between the center and the edges. This feature allows the user to zoom into a telephoto shot using the center section only, and still have high resolution.

In one example, when viewing the photograph in the wide field of view, the center pixels are "binned" or summed together to normalize the resolution to the value of the outer pixel density.

When viewing the photograph in telephoto mode, the center pixels are utilized in their highest resolution, showing maximum detail without requiring any adjustment of lens or camera settings.

The digital zoom feature offers extra wide angle to extreme telephoto zoom. This feature is enabled due to the extra resolving power, contrast, speed and color resolution lenses are able to deliver when the digital sensor is not flat, but curved, somewhat like the retina of a human eye. The average human eye, with a cornea and single lens element, uses, on average, 25 million rods and 6 million cones to capture images. This is more image data than is captured by all but a rare and expensive model or two of the cameras that are commercially available today, and those cameras typically must use seven to twenty element lenses, since they are constrained by flat sensors. These cameras cannot capture twilight images without artificial lighting, or, by boosting the ISO which loses image detail. These high-end cameras currently use sensors with up to 48 millimeter diagonal areas, while the average human eyeball has a diameter of 25 millimeters. Eagle eyes, which are far smaller, have eight times as many sensors as a human eye, again showing the optical potential that a curved sensor or retina provides. Examples and embodiments of the present invention are more dependable, cheaper and provide higher performance. Interchangeable lenses are no longer necessary, which eliminates the need for moving mirrors and connecting mechanisms. Further savings are realized due to simpler lens designs, with fewer elements, because flat film and sensors, unlike curved surfaces, are at varying distances and angles from the light coming from the lens. This causes chromatic aberrations and varying intensity across the sensor. To compensate for that, current lenses, over the last two centuries, have mitigated the problem almost entirely, but, with huge compromises. Those compromises include limits on speed, resolving power, contrast, and color resolution. Also, the conventional lens designs require multiple elements, some aspheric lenses, exotic materials and special coatings for each surface. Moreover, there are more air to glass surfaces and more glass to air surfaces, each causing loss of light and reflections.

### Variable Density of Pixels

In some examples and embodiments of the present invention, the center of the sensor, where the digitally zoomed telephoto images are captured, is configured with dense pixilation, which enables higher quality digitally zoomed images.

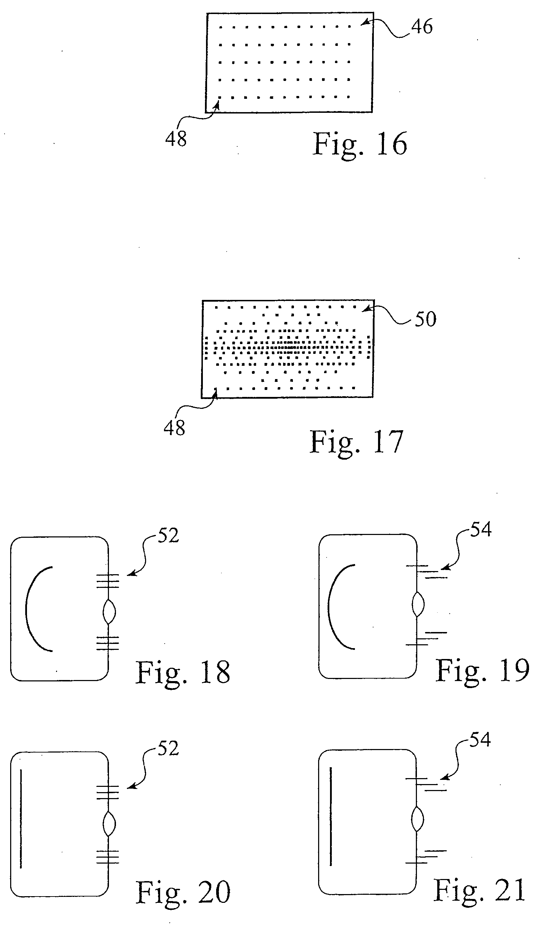

Figures 16 and 17 illustrate this feature, which utilizes a high density concentration of pixels 48 at the center of a sensor. By concentrating pixels near the central region of the sensor, digital zoom becomes possible without loss of image detail. This unique approach provides benefits for either flat or curved sensors. In Figure 16, a conventional sensor 46 is shown, which has pixels 48 that are generally uniformly disposed over the surface of the sensor 46. Figure 17 shows a sensor 50 produced in accordance with the present invention, which has pixels 48 that are more densely arranged toward the center of the sensor 50.

In another example, suitable software compresses the dense data coming from the center of the image when the camera senses that a wide angle picture is being taken. This feature greatly reduces the processing and storage requirements for the system.

### Lens Shade

Other examples include a lens shade, which senses the image being captured, whether wide angle or telephoto. When the camera senses a wide angle image, it retracts the shade, so that the shade does not get into the image area. When it senses the image is telephoto, it extends, blocking extraneous light from the non-image areas, which can cause flare and fogged images.

Figures 18 and 19 provide views of a camera equipped with an optional retractable lens shade. For wide angle shots, the lens shade is retracted, as indicated by reference character 52. For telephoto shots, the lens shade is extended, as indicated by reference character 54.

Figures 20 and 21 provide similar views to Figures 18 and 19, but of a camera with a planar sensor, indicating that the lens shade feature is applicable independently.

### Dust Reduction

Examples and embodiments of the present invention reduce the dust problem that plagues conventional cameras since no optical zoom or lens changes are needed. Accordingly, the camera incorporated into the mobile communication device is sealed. No dust enters to interfere with image quality. An inert desiccated gas, such as Argon, Xenon or Krypton may be sealed in the lens and sensor chambers within the enclosure 14, reducing oxidation and condensation. If these gases are used, the camera also gains benefits from their thermal insulating capability and temperature changes will be moderated, and the camera can operate over a wider range of temperatures.

### Completely Sealed Cameras

In another example of the invention, the entire camera may be sealed with an inert gas, such as Argon, Krypton or Xenon.

### Improved Optical Performance

The present invention may be used in conjunction with a radically high speed lens, useable for both surveillance without flash (or without floods for motion) or fast action photography. This becomes possible again due to the non-planar sensor, and makes faster ranges like a f/0.7 or f/0.35 lens designs, and others, within practical reach, since the restraints posed by a flat sensor (or film) are now gone.

All these enhancements become practical since new lens formulas become possible. Current lens design for flat film and sensors must compensate for the "rainbow effect" or chromatic aberrations at the sensor edges, where light travels farther and refracts more. Current lens and sensor designs, in combination with processing algorithms, have to compensate for the reduced light intensity at the edges. These compensations limit the performance possibilities.

Since the camera lens and body are sealed, an inert gas like Argon, Xenon or Krypton may be inserted, *e.g*., injected during final assembly, reducing corrosion and rust. The camera can then operate in a wider range of temperatures. This is both a terrestrial benefit, and, is a huge advantage for cameras installed on satellites.

### Rotating & Shifted Sensors

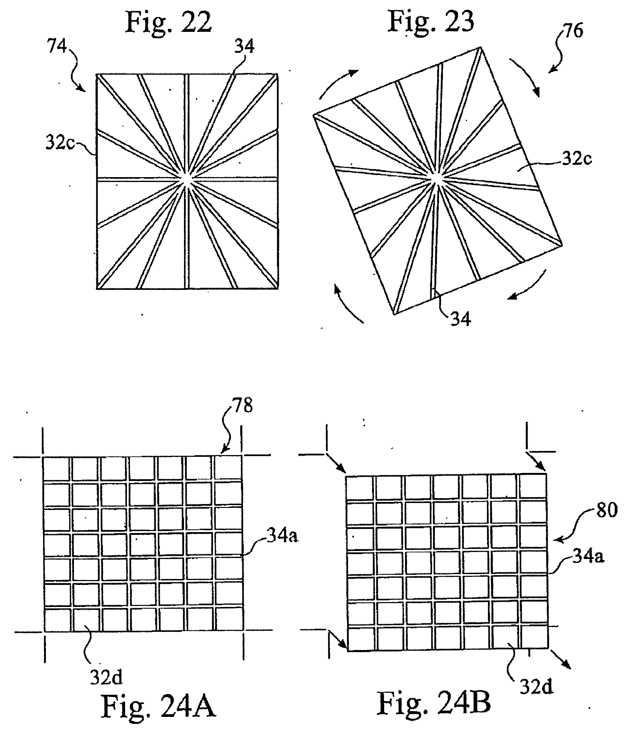

Figures 22 and 23 illustrate a series of alternative sensor arrays with sensor segments 32c separated by gaps 34, to facilitate easier sensor assembly. In this example, a still camera which utilizes this sensor array takes two pictures in rapid succession. A first sensor array is shown in its original position 74, and is also shown in a rotated position 76. The position of the sensor arrays changes between the times the first and second pictures are taken. Software is used to recognize the images missing from the first exposure, and stitches that data in from the second exposure. The change in the sensor motion or direction shift may vary, depending on the pattern of the sensor facets.

A motion camera can do the same, or, in a different embodiment, can simply move the sensor and capture only the new image using the data from the prior position to fill in the gaps in a continuous process.

This method captures an image using a moveable sensor with gaps between the sensors in its array of sensors. This method makes fabricating much easier, because the spaces between segments become less critical. So, in one example, a square sensor in the center is surrounded by a row of eight more square sensors, which, in turn, is surrounded by another row of sixteen square sensors. The sensors are sized to fit the circular optical image, and each row curves in slightly more, creating the non-planar total sensor.

In use, the camera first takes one picture. The sensor immediately rotates or shifts slightly and a second image is immediately captured. Software can tell where the gaps were and stitches the new data from the second shot into the first. Or, depending on the sensor's array pattern, it may shift linearly in two dimensions, and possibly move in an arc in the third dimension to match the curve.

This concept makes the production of complex sensors easier. The complex sensor, in this case, is a large sensor comprising multiple smaller sensors. When such a complex sensor is used to capture a focused image, the gaps between each sensor lose data that is essential to make the complete image. Small gaps reduce the severity of this problem, but smaller gaps make the assembly of the sensor more difficult. Larger gaps make assembly easier and more economical, but, create an even less complete image. The present method, however, solves that problem by moving the sensor after the first image, and taking a second image quickly. This gives the complete image and software can isolate the data that is collected by the second image that came from the gaps and splice it into the first image.

The same result may be achieved by a moving or tilting lens element or a reflector that shifts the image slightly during the two rapid sequence exposures. In this example, the camera uses, but changes in a radical way, an industry technique known as "image stabilization." The camera may use image stabilization in both the first and second images. This method neutralizes the effect of camera motion during an exposure. Such motion may come from hand tremors or engine vibrations. However, in this embodiment, after the first exposure, the camera will reverse image stabilization and introduce "image de-stabilization" or "intentional jitter" to move the image slightly over the sensor for the second exposure. This, with a sensor fixed in its position, also gives a shift to the second exposure so the gaps between the facets from the first exposure can be detected, and, the missing imagery recorded and spliced into the final image.

In one example shown in Figure 23, the sensor rotates back and forth. In an alternative example, the sensor may shift sideways or diagonally. The sensor may also be rotated through some portion of arc of a full circle. In yet another embodiment, the sensor might rotate continuously, while the software combines the data into a complete image.

Figures 24A and 24B also shows a second set of sensors. The sensor is first shown in its original position 78, and is then shown in a displaced position 80.

### Sensor Grid Patterns

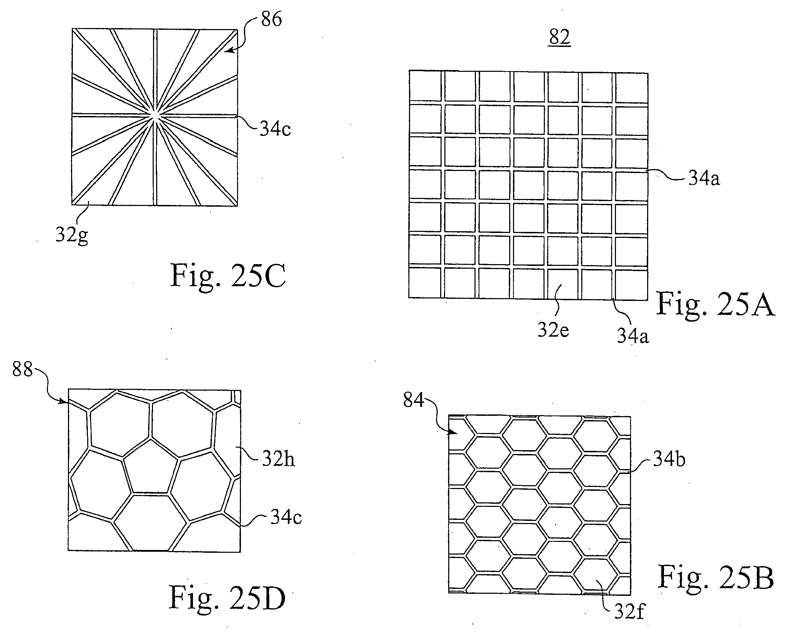

Figures 25A, 25B, 25C and 25D reveal four alternative grid patterns for four alternative embodiments of sensors 82, 84, 86 and 88. The gaps 34 between the facets 32e, 32f, 32g and 32h enable the manufacturing step of forming a curved sensor.

### Electrical Connections to Sensors

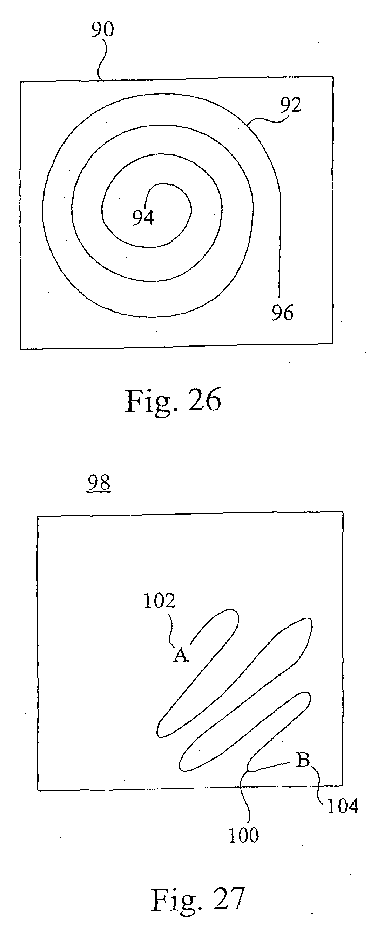

Figures 26, 27 and 28 provide views of alternative examples of electrical connections to sensors.

Figure 26 shows a sensor 90 has a generally spiral-shaped electrical connector
92. The conductor is connected to the sensor at the point identified by reference character 94, and is connected to a signal processor at the point identified by reference character 96. This example of an electrical
connection may be used when the sensor is rotated slightly between a first and second exposure, as illustrated in Figure 23. This arrangement reduces the flexing of the conductor 92, extending its life. The processor may be built into the sensor assembly.

Figure 27 shows the back of a sensor 102 with an "accordion" shape conductor 100, which is joined to the sensor at point A and to a processor at point B. This example may be used when the sensor is shifted but not rotated between a first and second exposure, as illustrated in Figure 24.

This type of connection, like the coiled wire connection, make an oscillating sensor connection durable.

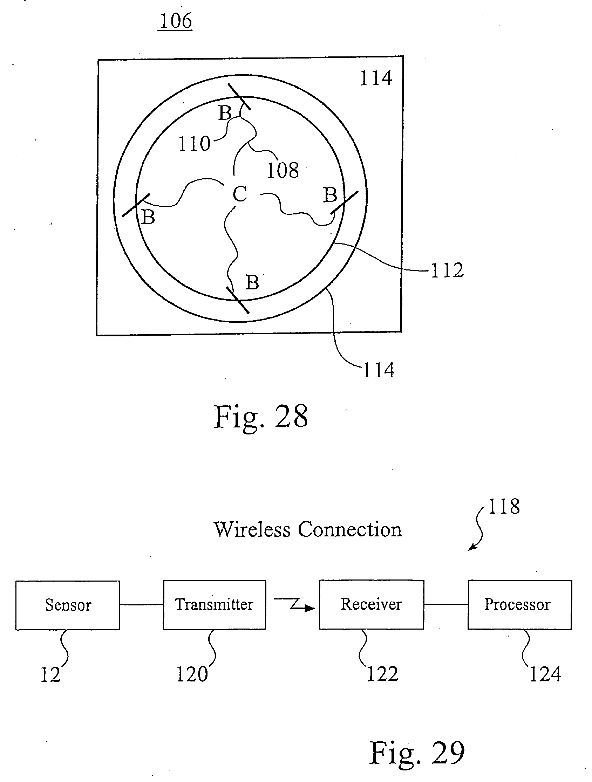

Figure 28 shows the back of a sensor 114 having generally radially extending conductors. The conductors each terminate in brush B which are able to contact a ring. The brushes move over and touch the ring, collecting an output from the rotating sensor, and then transmit the output to the processor at the center C. This example may be used when the sensor is rotated between exposures. In addition, this connection makes another embodiment possible; a continuously rotating sensor. In that embodiment, the sensor rotates in one direction constantly. The software detects the gaps, and fills in the missing data from the prior exposure. Wireless Connection

Figure 29 offers a block diagram of a wireless connection 118. A sensor 12 is connected to a transmitter 120, which wirelessly sends signals to a receiver 122. The receiver is connected to a signal processor 124.

In summary, the advantages offered by the present invention include, but are not limited to:
High resolution digital zoom
Faster
Lighter
Cheaper
Longer focusing ranges
More reliable
Lower chromatic aberration
More accurate pixel resolution
Eliminate need for flash or floodlights
Zooming from wide angle to telephoto

### III. Additional Examples

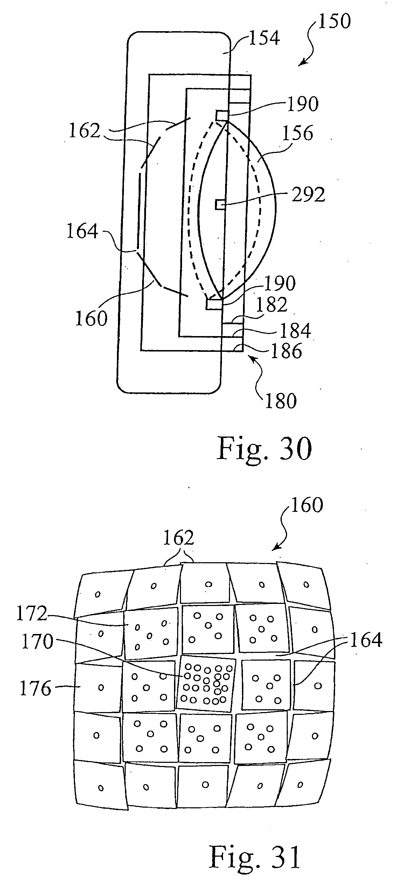

A mobile communication device including a camera 150 having many of the preferred features of the present invention will now be described with reference to Figures 30 and 31.

It will be understood that numerous conventional features such as a battery, shutter release, aperture monitor and monitor screen have been omitted for the purposes of clarity.

The camera comprises an hermetically-sealed enclosure 154 accommodating a generally curved sensor 160 and a lens 156. Enclosure 154 is filled with Argon, Xenon or Krypton. A front view of the sensor 160 is illustrated schematically in Fig. 31 and comprises a plurality of flat square pixel elements or facets 162 arranged to be relatively inclined so as to form an overall curved configuration. To minimize the area of the substantially triangular gaps 164 which result between the elements 162, the center square 170 is the largest, and the adjacent ring of eight squares 172 is made of slightly smaller squares so that they touch or nearly touch at their outermost corners. The next ring of sixteen squares 176 has slightly smaller squares than the inner ring 172.

The center square 170 has the highest density of pixels; note that this square alone is used in the capture of telephoto images. The squares of inner ring 172 have medium density pixilation, which for normal photography gives reasonable definition. The outer ring 176 of sixteen squares has the least dense pixel count.

In this example, the gaps 164 between the elements 162 are used as pathways for electrical connectors.

The camera 150 further comprises a lens shade extender arrangement 180 comprising a fixed, inner shade member 182, first movable shade member 184 and a second, radially outermost, movable shade member 186. When the operator is taking a wide angle photograph, the shade members are in a retracted disposition as shown in Fig. 30; only stray light from extremely wide angles is blocked. In this mode, to reduce data processing time and storage requirements, the denser pixel data from the central portions 170, 172 of the curved sensor can be normalized across the entire image field to match the less dense pixel counts of the edge facets 176 of the sensor.

For a normal perspective photograph, the shade member 184 is extended so that stray light from outside of the viewing area is blocked. In this mode, a portion of the data facets 172 of the curved sensor are compressed. To reduce processing time and storage requirements, the data from the most center area 170, with higher density of pixels, can be normalized across the entire image field.

When the user zooms out digitally to a telephoto perspective, shade member 186 is extended. In this mode, only the center portion 170 of the curved sensor 160 is used. Since only that sensor center is densely covered with pixels, the image definition will be crisp.

In operation, camera 150 uses two exposures to fill in any gaps within the sensors range, *i.e.,* to obtain the pixel data missing from a single exposure due to the presence of gaps 164. For this purpose, the camera deploys one of two methods. In the first, as previously described, the sensor moves and a second exposure is taken in rapid succession. The processing software detects the image data that was missed in the first exposure, due to the sensor's gaps, and "stitches" that missing data into the first exposure. This creates a complete image. The process is run continuously for motion pictures, with the third exposure selecting missing data from either the preceding or the following exposure, again to create a complete image.

In the second method, a radical change to the now-standard process known in the industry as "image stabilization" is used. For the first exposure, the image is stabilized. Once recorded, this "image stabilization" is turned off, the image is shifted by the stabilization system, and the second image is taken while it is re-stabilized. In this method, a complete image is again created, but without any motion required of the sensor.

The dashed lines shown in Figure 30 indicate the two-dimensional motion of the lens for one embodiment of the focusing process. In another example that includes intentional jittering, the lens does not move back and forth, but, rather, tilts to alter the position of the image on the sensor.

The above-described camera 150 has numerous advantages. The sealing of the enclosure 154 with a gas like argon prevents oxidation of the parts and provides thermal insulation for operation throughout a broader range of temperature.

Although the center square 170 with a high pixel density, which is relatively more expensive, it is also relatively small, and it is only necessary to provide a single such square, this keeping down the overall cost. A huge cost advantage is that it provides an acceptable digital zoom without the need for accessory lenses. Accessory lenses cost far, far more than this sensor, and are big, heavy and slow. The outer ring 176 has the smallest squares and the lowest pixel count and so they are relatively inexpensive. Thus, taking into account the entire assembly of squares, the total cost of the sensor is low, bearing in mind it is capable of providing an acceptable performance over a wide range of perspectives.

Numerous modifications may be made to the camera 150. For example, instead of being monolithic, lens 156 may comprise a plurality of elements.

The enclosure 154 is sealed with another inert gas, or a non-reactive gas such as Nitrogen, Krypton, Xenon or Argon; or it may not be sealed at all.

The pixels or facets 170, 172, 176 may be rectangular, hexagonal or of any other suitable shape. Although a central pixel and two surrounding "square rings" of pixels are described, the sensor may comprise any desired number of rings.

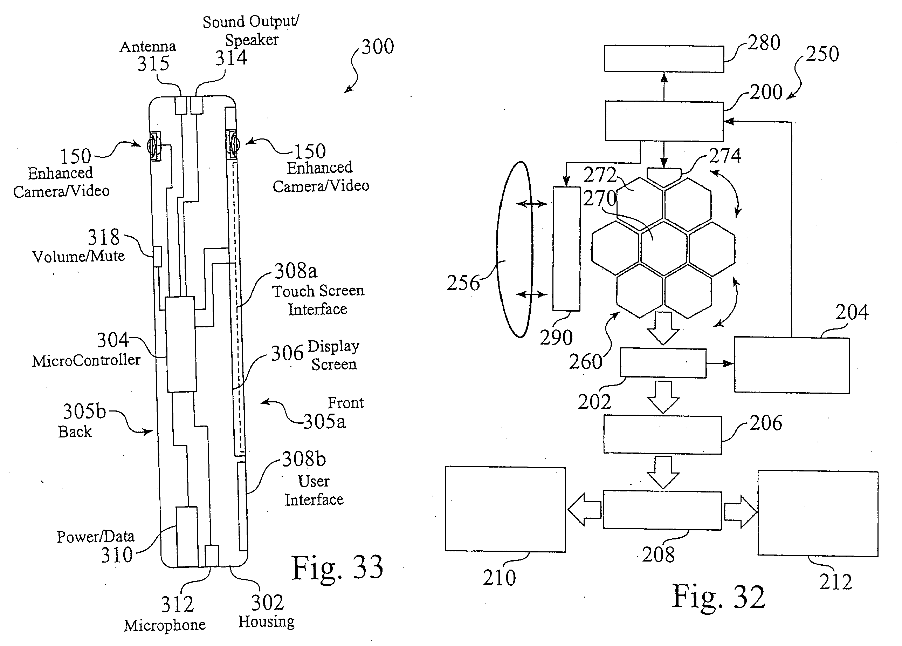

In Figure 32, there is shown a block diagram of a camera 250 having many of the features of the camera 150 of Figures 30 and 31. A non-planar sensor 260 has a central region 270 with high pixel density and a surrounding region comprising facets 272 with low pixel density. A shutter control 274 is also illustrated. The shutter control 274 together with a focus/stabilization actuating mechanism 290 for lens 256 and a lens shade actuator 280 are controlled by an image sequence processor 200. The signals from pixels in facets 270, 272 are supplied to a raw sensor capture device 202. An output of device 202 is connected to a device 204 for effecting auto focus, auto exposure/gain and auto white balance. Another output of device 202 is supplied to a device 206 for effecting pixel density normalization, the output of which is supplied to an image processing engine 208. A first output of engine 208 is supplied to a display/LCD controller 210. A second output of engine 208 is supplied to a compression and storage controller 212.

The features and modifications of the various examples and embodiments described may be combined or interchanged as desired.

### IV. Mobile Communicator with a Curved Sensor Camera

Figures 33, 34, 35 and 36 present views of one example, which combines a curved sensor camera with a mobile communication device. The device may be a cellular telephone; laptop, notebook or netbook computer; or any other appropriate device or means for communication, recordation or computation.

Figure 33 shows a side view 300 of one particular example of the device, which includes an enhanced camera 150 for still photographs and video on both the front 305a and the back 305b sides. A housing 302 encloses a micro-controller 304, a display screen 306, a touch screen interface 308a and a user interface 308b. A terminal for power and/or data 310, as well as a microphone, are located near the bottom of the housing 302. A volume and/or mute control switch 318 is mounted on one of the slender sides of the housing 302. A speaker 314 and an antenna 315 reside inside the upper portion of the housing 302.

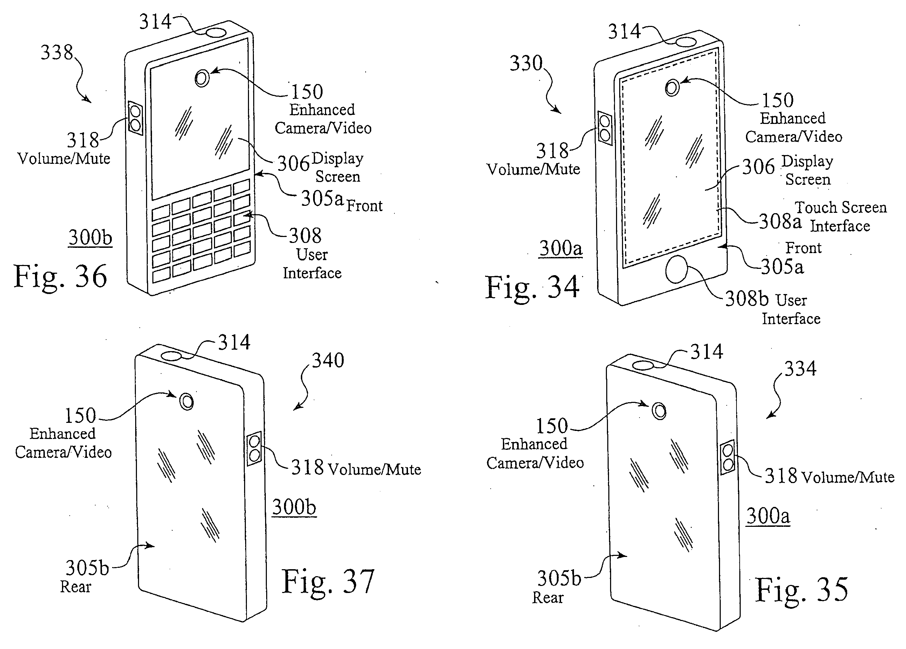

Figures 34 and 35 offer perspective views 330 and 334 of an alternative embodiment 300a. Figures 36 and 37 offer perspective views 338 and 340 of yet another alternative embodiment 300b.

### V. Method to Capture More Detail from a Scene than the Sensor is Otherwise Capable of Recording

This alternative method uses multiple rapid exposures with the image moved slightly and precisely for each exposure.

In the illustrated example, four exposures are taken of the same scene, with the image shifted by ½ pixel in each of four directions for each exposure. (In practice, three, four, five or more exposures might be used with variations on the amount of image shifting used.)

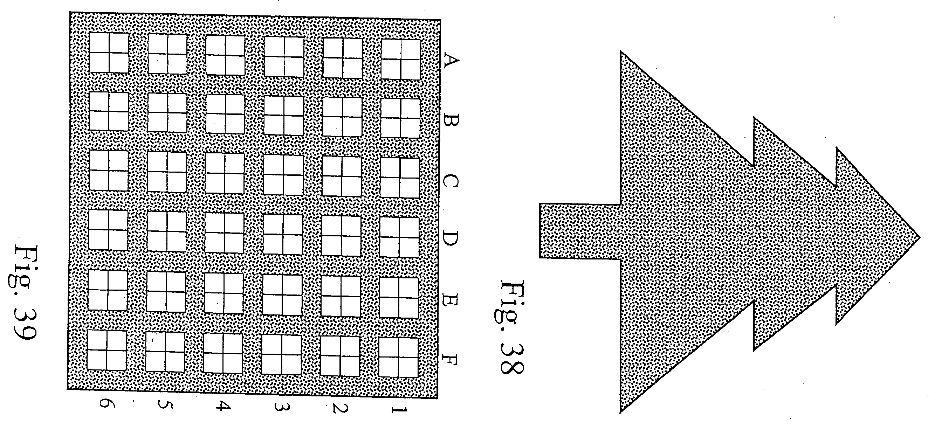

For this example, Figure 38 shows a tree. In this example, it is far from the camera, and takes up only four pixels horizontally and the spaces between them, plus five pixels vertically with spaces.

(Cameras are currently available at retail with 25 Megapixel resolution, so this tree image represents less than one millionth of the image area and would be undetectable by the human eye without extreme enlargement.)

Figure 39 represents a small section of the camera sensor, which might be either flat or curved. For the following explanation, vertical rows are labeled with letters and horizontal rows are labeled with numbers. The dark areas represent spaces between the pixels.

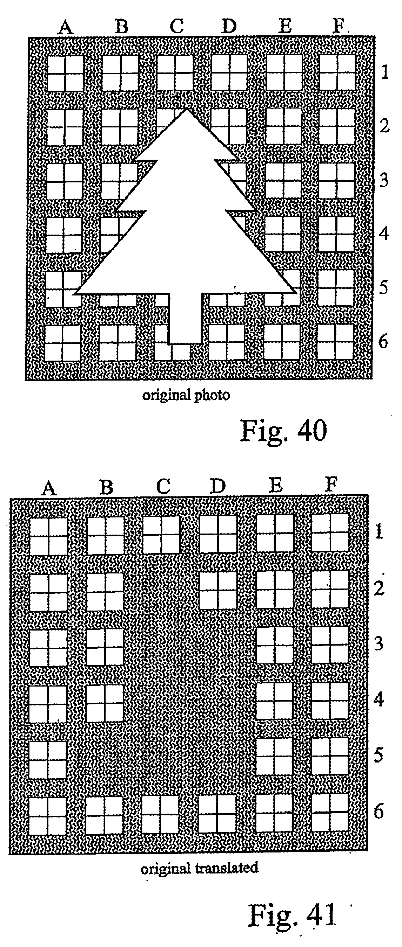

Figure 40 shows how the tree's image might be first positioned on the pixels. Note that only pixels C2, C3, D3, C4, D4, B5, C5 and D5 are "more covered than not" by the tree image. Those, then, are the pixels that will record its image.

Figure 41 then shows the resulting image that will represent the tree from this single exposure. The blackened pixels will be that first image.

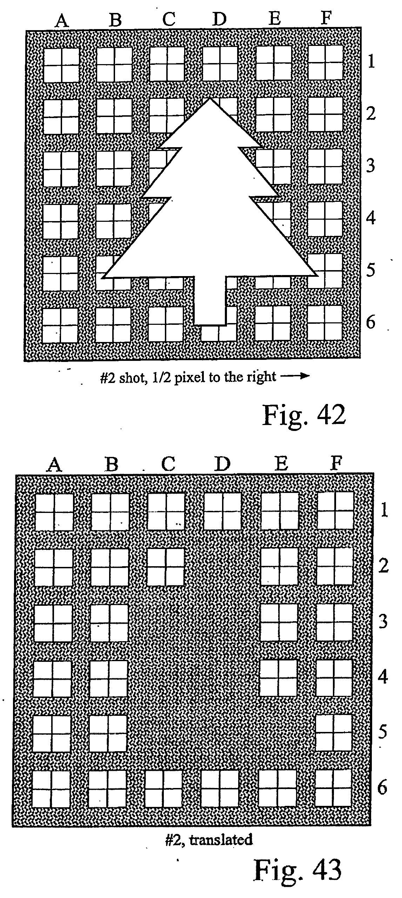

Figure 42, however, represents a second exposure. Note that the image for this exposure has been shifted by ½ pixel to the right. This shift might be done by moving the sensor physically, or, by reversing the process known in the industry as "image stabilization." Image stabilization is a method to eliminate blur caused by camera movement during exposures. Reversing that process to move the image focused on the sensor, for the additional exposures, and reversing only between those exposures, is a unique concept and is claimed for this invention.

With Figure 42, the resulting pixels that are "more covered than not" by the image are D2, C3, D3, C4, D4, (E4 might go either way,) C5, D5 and E5.

This results in a data collection for this image as shown by Figure 43.

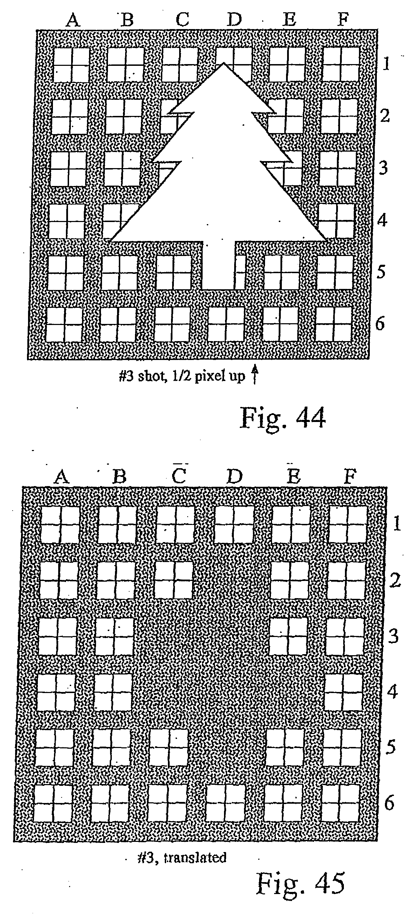

Figure 44 represents a third exposure. This time the image is moved up from exposure 2 by ½ pixel. The results are that the tree is picked up on pixels D2, C3, D3, C4, D4, E4 and D5.

This third exposure, then, is represented by data collected as shown in Figure 45.

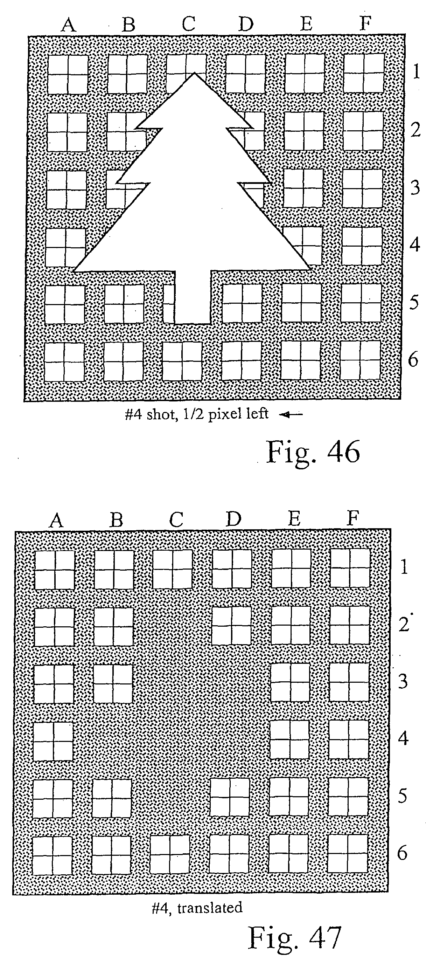

Figure 46 continues the example. In this case, the image is now shifted to the left by ½ pixel from the third exposure. The result is that imagery is caught by pixels C2, C3, D3, B4, C4, D4 and C5.

Figure 47 represents that fourth recorded image.

Now the camera has four views of the same tree image.

Current image stabilization neutralizes tiny hand tremors and even some motor or other vibrations during a single exposure, eliminating blur. That capability suggests moving the image to second, third and fourth or more positions can occur quickly.

Pixel response times are also improving regularly, to the point that digital cameras that were formerly only still cameras, have, for the most part, also become motion picture cameras in subsequent model enhancements. This also suggests that rapid multiple exposures can be done; particularly since this is the essence of motion photography.

What has not been done or suggested is changing the mode of the image stabilization mechanism so that it moves the image slightly, and by a controlled amount, for each of the multiple exposures, while stabilizing the image during each exposure.

Alternatively, moving the sensor slightly for the same effect is also a novel method.

Software interprets the four captured images. The software "looks" at Figures 45 and 47, and concludes that whatever this image is, it has a stub centered at the bottom. Because this stub is missing from Figures 41 and 43, the software concludes that it is one pixel wide and is a half pixel long.

The software looks at all four figures and determine that whatever this is, it has a base that's above that stub, and that base is wider than the rest of the image, going three pixels horizontally. This comes from line five in Figures 41 and 43 plus line four in Figures 45 and 47.

The software looks at lines three and four in Figure 41 and Figure 43 and conclude that there is a second tier above the broad base in this image, whatever it is, that is two pixels wide and two pixels tall.

But, the software also looks at lines three in Figure 45 and Figure 47, confirming that this second tier is two pixels wide, but, that it may only be one pixel tall.

The software averages these different conclusions and make the second tier 1 ½ pixels tall.

The software looks at line two in all four images and realize that there is a narrower yet image atop the second tier. This image is consistently one pixel wide and one pixel high, sits atop the second tier but is always centered over the widest bottom tier, and the stub when the stub appears.

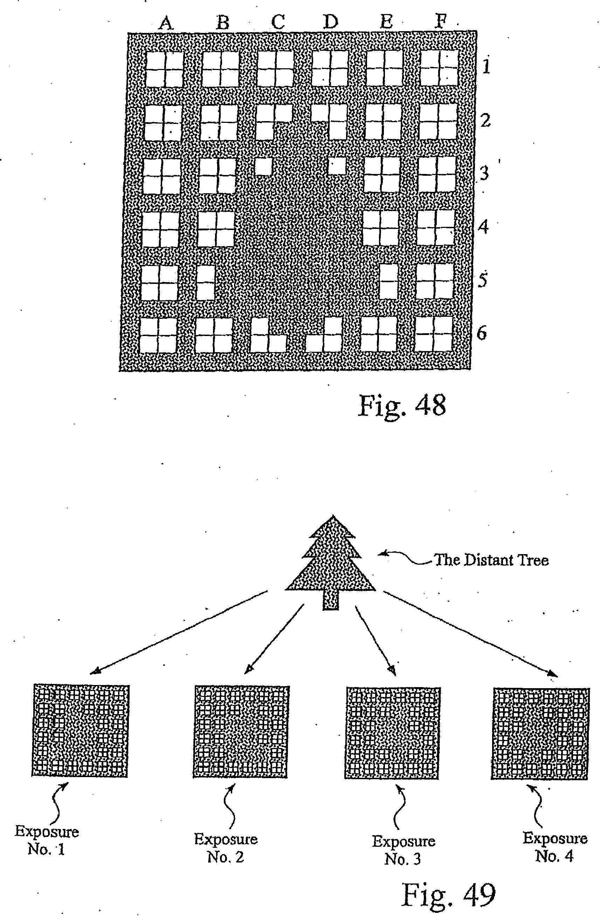

Figure 48 shows the resulting data image recorded by taking four images, each ½ pixel apart from the adjoining exposures taken. Note that since the data has four times as much information, the composite image, whether on screen or printed out, will produce 1/4 fractions of pixels. This shows detail that the sensor screen was incapable of capturing with a single exposure.

Figure 49 shows the original tree image, as it would be digitally recorded in four varying exposures on the sensor, each positioned ½ pixel apart. Figure 49 shows the tree itself, and the four typical digital images that would be recorded by four individual exposures of that tree. None look anything like a tree.

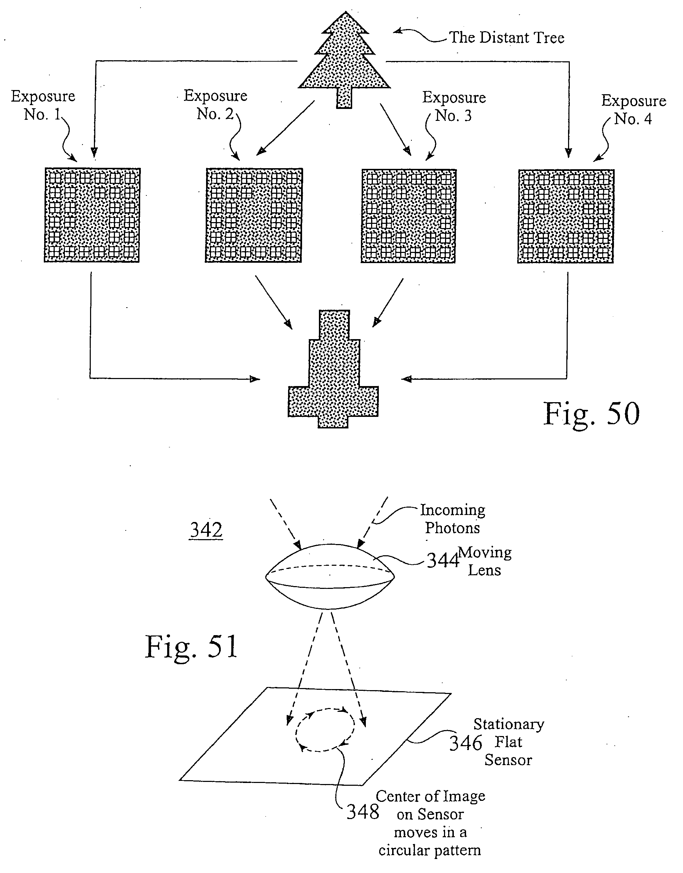

The tree is captured digitally four times. Figure 50 shows how the original tree breaks down into the multiple images, and, how the composite, created by the software from those four images, starts to resemble a tree. The resemblance is obviously not perfect, but is closer. Considering that this represents about 0.000001% of the image area, this resemblance could help some surveillance situations.

### VI. Alternative Method for Forming a Curved Sensor

One example of this method proposes to create a concave mold to shape the silicon after heating the wafer to a nearly molten state. Gravity then settles the silicon into the mold. In all of these methods, the mold or molds could be chilled to maintain the original thickness uniformly by reducing the temperature quickly. Centrifuging is a second possible method. The third is air pressure relieved by porosity in the mold. A fourth is steam, raised in temperature by pressure and/or a liquid used with a very high boiling point. The fourth is simply pressing a convex mold onto the wafer, forcing it into the concave mold, but again, doing so after raising the temperature of the silicon.

Heating can occur in several ways. Conventional "baking" is one. Selecting a radiation frequency that affects the silicon significantly more than any of the other materials is a second method. To enhance that second method, a lampblack-like material that absorbs most of the radiation might be placed on the side of the silicon that's to become convex, and is removed later. It absorbs the radiation, possibly burns off in the process but heats the thickness of the wafer unevenly, warming the convex side the most, which is where the most stretching occurs. A third method might be to put this radiation absorbing material on both surfaces, so the concave side, which absorbs compression tension and the convex side, which is pulled by tensile stresses, are each heated to manage these changes without fracturing.

A final method is simply machining, polishing or laser etching away the excess material to create the curved sensor.

In this example, the curved surface is machined out of the silicon or other ingot material. The ingot would be thicker than ordinary wafers. Machining could be mechanical, by laser, ions or other methods.

In the second example, the wafer material is placed over a pattern of concave discs. Flash heating lets the material drop into the concave shape. This may be simply gravity induced, or, in another embodiment, may be centrifuged. Another enhancement may be to "paint" the backside with a specific material that absorbs a certain frequency of radiation to heat the backside of the silicon or other material while transmitting less heat to the middle of the sensor. This gives the silicon or other material the most flexibility across the side being stretched to fit the mold while the middle, is less heated, holding the sensor together and not being compressed or stretched, but only bent. In another example, the frontside is "painted" and irradiated, to allow that portion to compress without fracturing. In another embodiment, both sides are heated at the same time, just before reforming.

Radiation frequency and the absorbent "paint" would be selected to minimize or eliminate any effect on the dopants if already inserted.

### VII. Improving Image Details

In another example, a generally constant motion is deliberately imparted to a sensor and/or an optical element while multiple exposures are taken. In another example, this motion may be intermittent. Software then processes the multiple exposures to provide an enhanced image that offers greater definition and edge detail. The software takes as many exposures as the user may predetermine.

In thins example, the sensor is arrayed with pixels having a variable density, with the highest density in the center of the sensors. When the sensor rotates, the motion on the outer edges is far greater than at the center. Taking pictures with less than a pixel diameter of motion results in enhanced detail that is captured in the composite image. The pixels at the outer edges, where they are least densely placed, will be the largest individual pixels. The center pixels, where concentration is greatest, will have the smallest pixels. In between those extremes, the sizes will gradually change and grow as the distance from the center increases. In this way, for a fraction of a degree in rotation, the same amount of pixel change across the image takes place, and, image definition can be enhanced in this rotating direction. When a second exposure is taken with a fraction of a pixel's rotation, more edge detail of the image is captured and enhanced.

### Fixed Sensor with Moving Image

In one alternative example, a stationary flat or curved sensor may be used to collect data or to produce an image using an image which moves in a circular motion. In one implementation of this example, the circular path of the image has a diameter which is generally less than the width of a pixel on the sensor. In one example, the circular path has a diameter which is half the width of a pixel. In this example, pixel density is constant across the sensor. If the image was a picture of a clock, it would move constantly in a small circle, with the number 12 always on top and the number 6 always on the bottom.

### Moving Sensor with Stationary Image

In yet another alternative example, a flat or curved sensor which generally constantly moves in a tight circle may be used to collect data or to produce an image. In one implementation of this example, the circular path of the moving sensor has a diameter which is generally less than the width of a pixel on the sensor. In one example, the circular path has a diameter which is half the width of a pixel. In other examples, the circular paths might have diameters of four and one half pixels, or six and one quarter pixels, or some other suitable diameter. The invention may be implemented using any movement that results in capturing added fractional images to provide detail beyond the normal pixel count's ability to detect.

The advantages of these examples include:
Elimination of any reciprocal movement
No vibration
No energy loss from stop and go motions

Figure 51 presents a schematic illustration 342 of an optical element 344 which moves over a flat sensor 346. The optical element 344 moves in a tight circular path over the flat sensor to move the incoming light over the surface of the flat sensor along a tight circular path 348. In this example, the optical element is shown as an objective lens. In other embodiments, any other suitable lens or optical component may be employed. In an alternative example, the optical element 344 may tilt or nutate back and forth in a generally continuous or intermittent motion that moves the image in a tight circle over the surface of the stationary flat sensor 346.

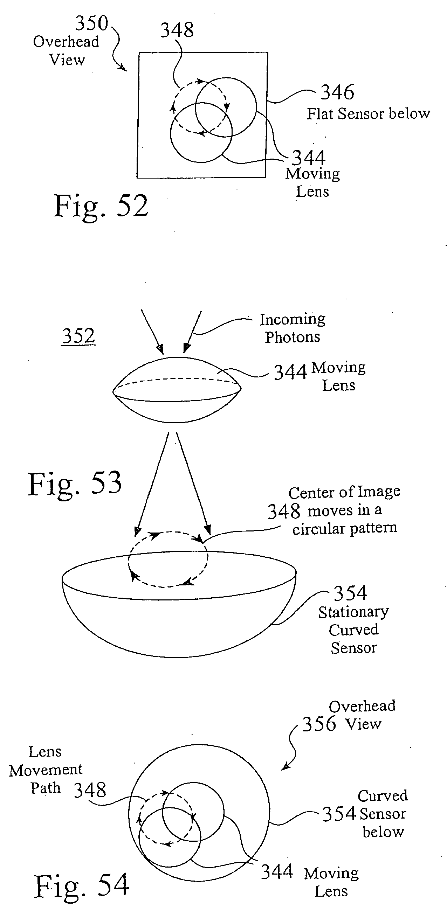

Figure 52 is an overhead view 350 of the same optical element 344 which moves over a the same stationary flat sensor 346 as shown in Figure 51. The optical element 344 moves in a tight circular path over the sensor 346 to move the incoming light over the surface of the flat sensor 346.

Figure 53 furnishes a schematic illustration 352 of an optical element 344 which moves over a stationary curved sensor 354.

Figure 54 is an overhead view 356 of the same optical element 344 and sensor 354 shown in Figure 53.

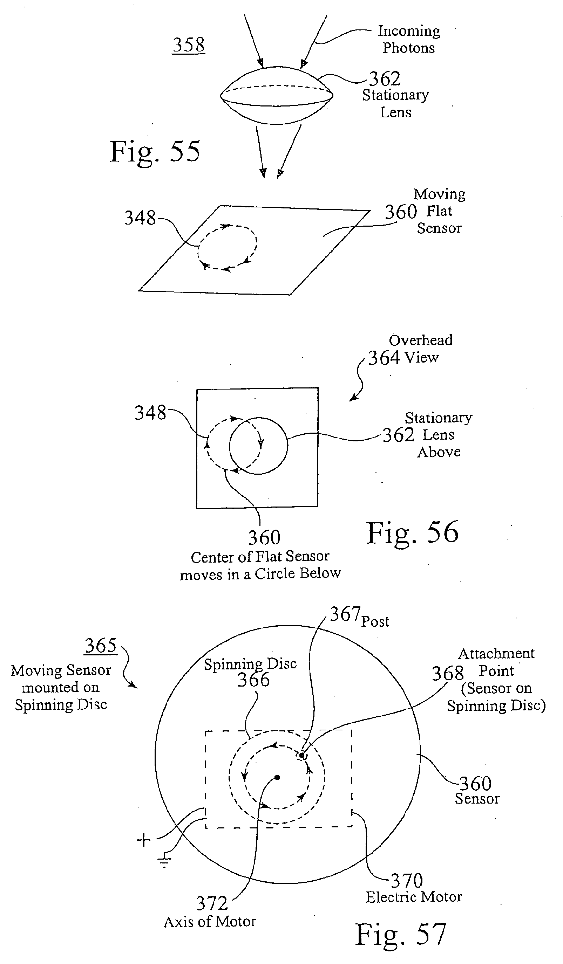

Figure 55 supplies a schematic illustration 358 of one method for imparting motion to a flat sensor 360 as it moves beneath a stationary optical element 362. Figure 56 is an overhead view 372 of the same stationary optical element 362 and sensor 360 as shown in Figure 55.

Figure 57 is an illustration 364 that reveals the details of the components which impart the spinning motion to the sensor 360 shown in Figures 55 and 56. The flat sensor 360 is attached to a post or connector 364 which is mounted on a spinning disc 366 which is positioned below the sensor 360. The attachment is made at an off-center location 368 on the disc which is not the center of the disc. The disc is rotated by an electric motor 370, which is positioned below the disc. The axis 372 of the motor is not aligned with the attachment point 368 of the connecting post 364.

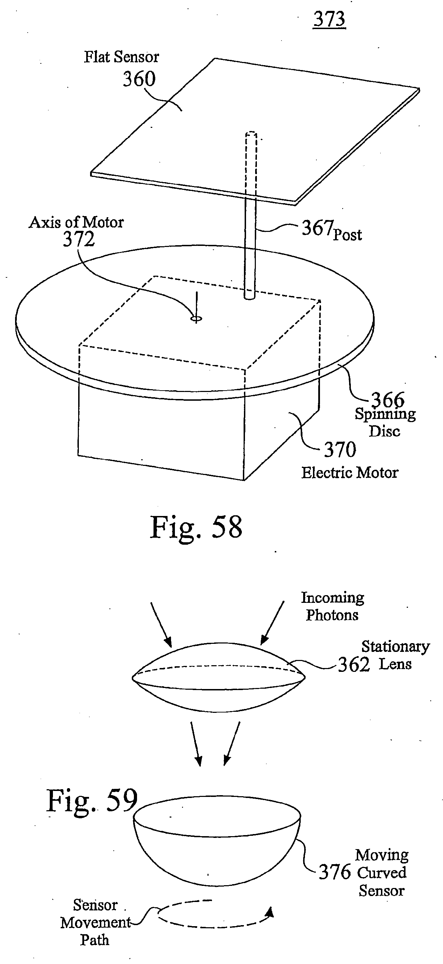

Figure 58 offers a perspective view of the components shown in Figure 57.

Figure 59 offers a schematic depiction 374 of a stationary optical element 362 which resides over a curved sensor 376 which moves below the fixed optical element 362.

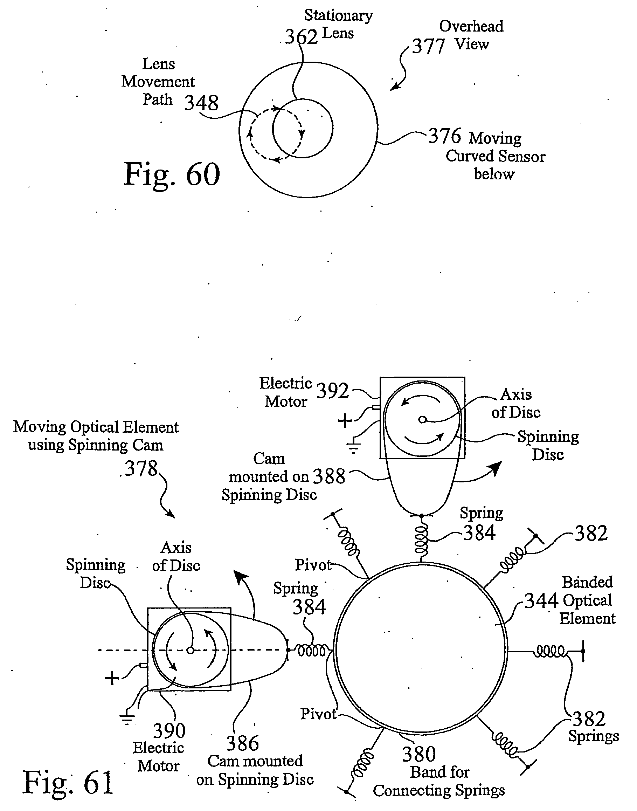

Figure 60 is an overhead view of the optical element 362 and sensor 376 shown in Figure 59.

Figure 61 furnishes an illustration 378 of a method for imparting a circular motion to an optical element 344 like the one shown in Figures 51 and 52. The optical element 344 is surrounded by a band 380, which provides pivoting attachment points 382 for a number of springs 384. Two of the springs are attached to cams 386 and 388, and each cam is mounted on an electric motor 390 and 392. When the cams rotate, the springs connected to the bands which surround the optical elements move the optical element. The two cams are out of phase by ninety degrees to provide circular motion.

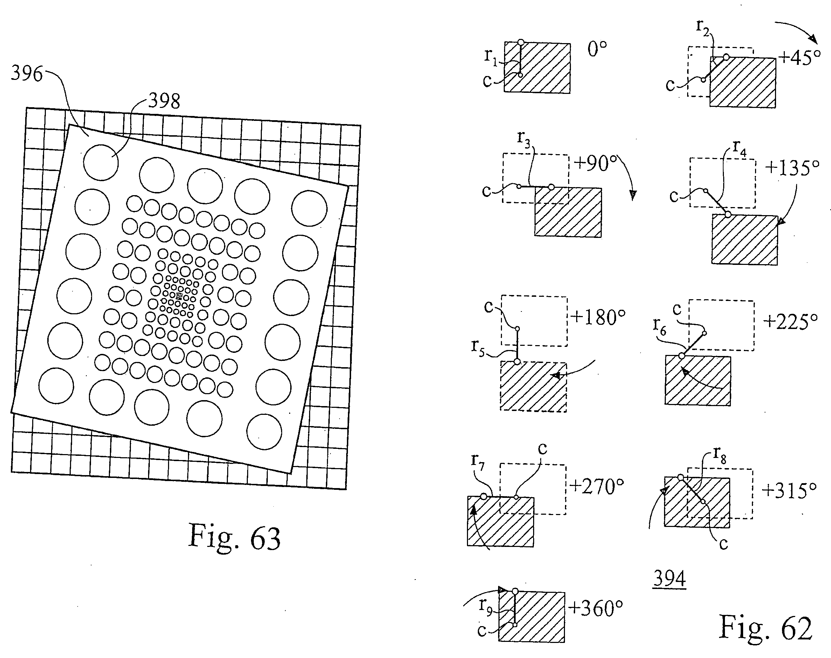

Figure 62 presents a series 394 of nine simplified views of a flat sensor as it moves through a single orbit in its circular path. In one embodiment, the circular path is less than one pixel in diameter. In each view, an axis of rotation C is shown, which lies near the lower left corner of the square sensor. A radius segment is shown in each successive view, which connects the axis of rotation to a point on the top side of each square. In each view, the square sensor has moved forty-five degrees in a clockwise direction about the axis of rotation, C. In each view, a dotted-line version of the original square is shown in its original position. The radius segments are numbered r₁ through r_{g}, as they move through each of the eight steps in the circle.

In alternative examples, the sensor depicted in Figure 62 may be configured in a rectangular or other suitable planar shape. In another alternative embodiment, the sensor may be curved or hemispherical. The motion may be clockwise, counter-clockwise or any other suitable displacement of position that accomplishes the object of the invention.

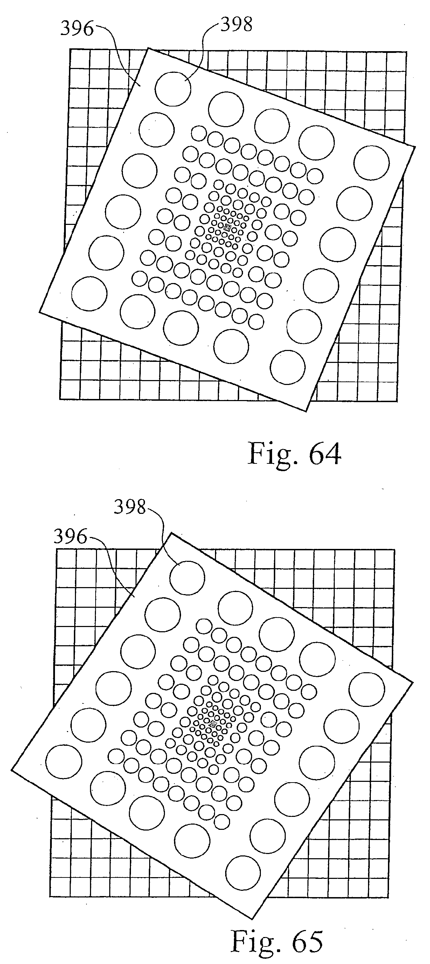

Figure 63 is a schematic representation of a flat sensor arrayed with pixels 396. In Figure 63, the sensor resides in its original position. In Figures 64 and 65, the sensor continues to rotate through the circular path. As the sensor rotates multiple exposures are taken, as determined by software. In this example, the outer and inner rows of pixels each move by the same number of pixel spaces.

This example enhances detail in an image beyond a sensor's pixel count, and may be used in combination with the method described in Section V, above, "Method to Capture More Detail from a Scene than the Sensor is Otherwise Capable of Recording."

While pixel density is increasing on sensors rapidly, when pixels are reduced in size such that each pixel can sense only a single photon, the limit of pixel density has been reached. Sensitivity is reduced as pixels become smaller.

This example may be utilized in combination with methods and apparatus for sensor connections described in US2010/0260494; See, especially, Paragraphs 101 - 113.

In yet another example, miniature radios may be used to connect the output of the sensor to a micro-processor.

### VIII. Alternative Example - Sensor Formed from Silicon Fiber Fabric

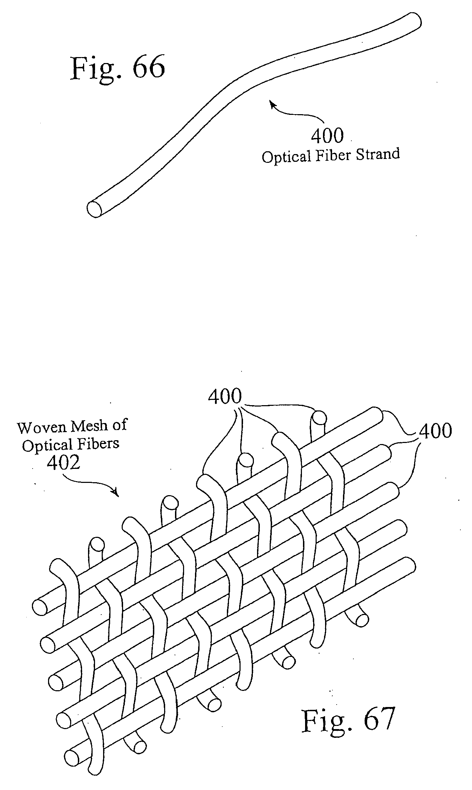

In yet another example, a sensor is formed from a fabric woven from silicon fibers. While this example employs silicon fibers, any light transmissive fiber material can be used that is suitable for this purpose. Figure 66 shows a single strand of silicon fiber 400, which has been manufactured from silicon. Figure 67 shows two sets of these fibers 400 which are being woven into a fabric 402. A first set of fibers is positioned so that they are all generally parallel to each other. A second set of fibers, which are positioned so that they are orthogonal to the first set of fibers, is then sequentially woven into the first set by threading each fiber over and then below each successive fiber. In traditional textile weaving, the first set of parallel fibers is called the "warp," while the set that is woven into the warp by threading under and then over each successive thread is called the "weft." Since the silicon threads will be fused by heat into a solid fabric, the weave need not be done over and under each thread, but, could be every other thread, every tenth thread, or other number. If ten warp threads were woven over and under ten weft threads, as one possible example, they could be woven together as ten threads. Alternatively, the first warp thread could go over ten weft threads, while the second warp thread might go over nine weft threads but continue going over and under ten weft threads after that. And, in this example, the third warp thread might go over eight weft threads before continuing the pattern of going over and under ten weft threads until the other end of the fabric.

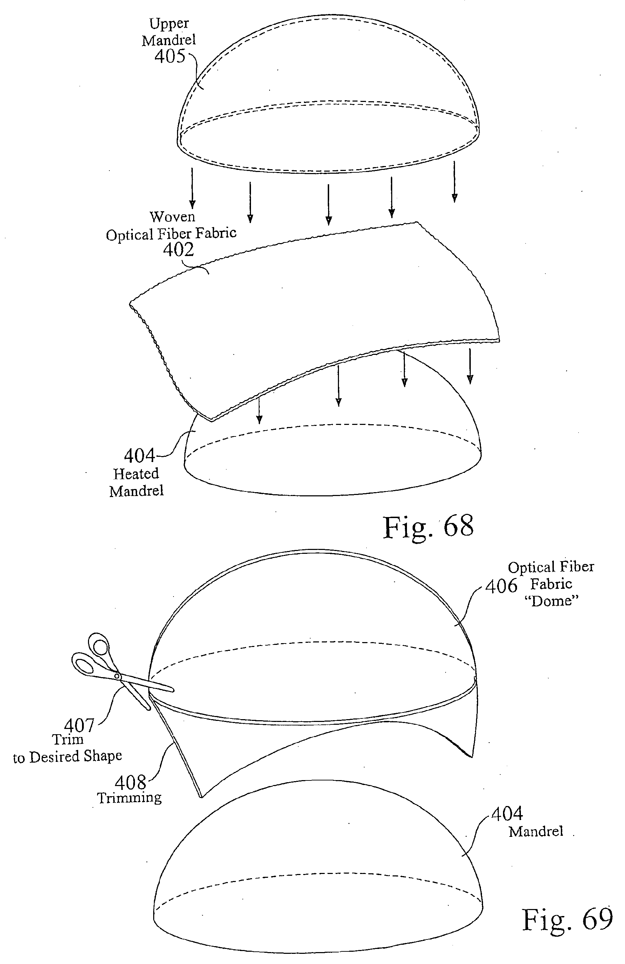

After the fabric 402 is woven, it is placed over a heated first mandrel 404, as shown in Figure 68. The first mandrel 404 has a curved upper surface. A second mandrel 505, which has a similar curved shape, is shown above the first mandrel 404. The woven fabric takes the shape of the mandrel, is heated, and the silicon fibers fuse together, as shown in Figure 69. A curved sensor 406 is formed, and the excess 408 is trimmed away.

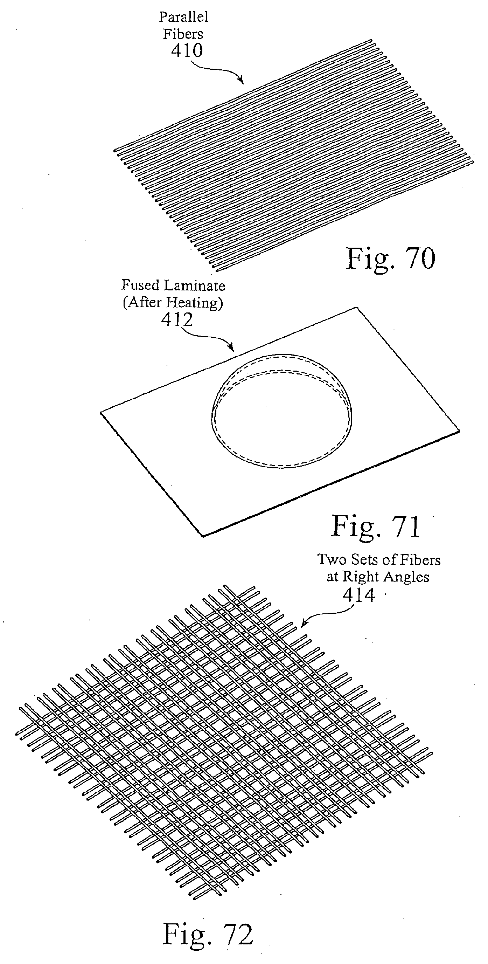

In an alternative example, a group of parallel fibers 410 is be formed into a single unwoven laminate 412, as shown in Figures 70 and 71. The unwoven laminate 412 is pressed between two mandrels, and is then heated. The silicon fibers fuse into a curved sensor. Just enough heat is used to make the silicon flexible while on the mandrel, to maintain that state, may be initially warm but could also be quickly chilled to stabilize the silicon into its final hemispherical shape.

In another variation, two sets of fibers may be laid at right angles 414, and then heated to form the fused laminate 416, as shown in Figure 72.

### IX. Alternative Embodiment: Curved Sensor Formed with Varying Mini-Sensor Sizes

In yet another embodiment of the invention, a curved sensor 418 is formed from a number of generally flat "mini-sensors" which are positioned to form a nearly curved surface. In this embodiment, a slightly different manufacturing process is employed for each successive row of mini-sensors. In an example not forming part of the claimed invention, the sensor may be a conventional planar sensor.

In thins example, each mini-sensor is slightly smaller than the adjoining inner row so their corners do not overlap as they tilt inward to create the curve. This creates gaps which were explained in previous portions of this Specification. These gaps also provide shorter average connections to the pixels, so less space is wasted. Since either the image or the sensor itself shift and take double exposures, as explained above, the entire surface captures imagery, creating a virtual 100% "fill factor." "Fill factor" is the industry phrase that measures the percentage area of a sensor that actually captures photons and converts them to signal data. In this embodiment, each has different pixel densities. The mini-sensor is the center of the entire sensor is the most dense, so digital zoom becomes palatable and crisp without undue expense. The next row out is less dense, saving cost, and the same amount of detail which is determined by the total pixel count is captured for normal perspective shots. The outside row (this example assumes three rows for simplicity) could is the least detailed, and, being the most numerous, is the cheapest to manufacture.

For just one of many possible examples, assume there are three rows of "mini-sensors" used to create the overall "nearly curved sensor." The center sensor, which would be used alone for telephoto photography during digital zooming, could contain 20 MP of sensors. This creates a superior telephoto image over optical zoom telephoto images. As a small, but densely pixilated "mini-sensor," its cost is competitive. Costs will be high due to the extremely dense pixilation. But that is counteracted by the small size required for this single "mini-sensor", so many more are created per wafer. Assume the second row surrounding this center sensor contain eight slightly smaller 2.5 MP "mini-sensors."

While the center "mini-sensor" is used for the maximum telephoto digital zoom imagery, when combined with the second surrounding row of "mini-sensors" the perspective changes to a normal photograph. Since the eight surrounding "mini-sensors" combine to create a 20 MP image, the center sensor is, in this embodiment, compressed down to 2.5 MP itself. This means the normal perspective photograph would be made up of 22.5 MP. Again, this is a detailed image. By compressing the center "mini-sensor" data, processing is faster and storage requirements are reduced. The massive detail from that center sensor is not needed when the image captured backs away from telephoto to a normal perspective.

Likewise, for an embodiment designed for wide angle photos, the outer row of sixteen "mini-sensors" are 1 MP each. But, since the inner rows and center "mini-sensor" are delivering unnecessary data amounts, they are all compressed to 1 MP each. This delivers a wide angle image of 25 MP, more than the human eye can resolve at an 8" x 10" enlargement. (There are 25 "mini-sensors" each delivering 1 MP of data.)

This configuration provides cost savings, as well as optimal megapixel counts for all three perspectives: telephoto, normal and wide angle, and for any perspective in between.

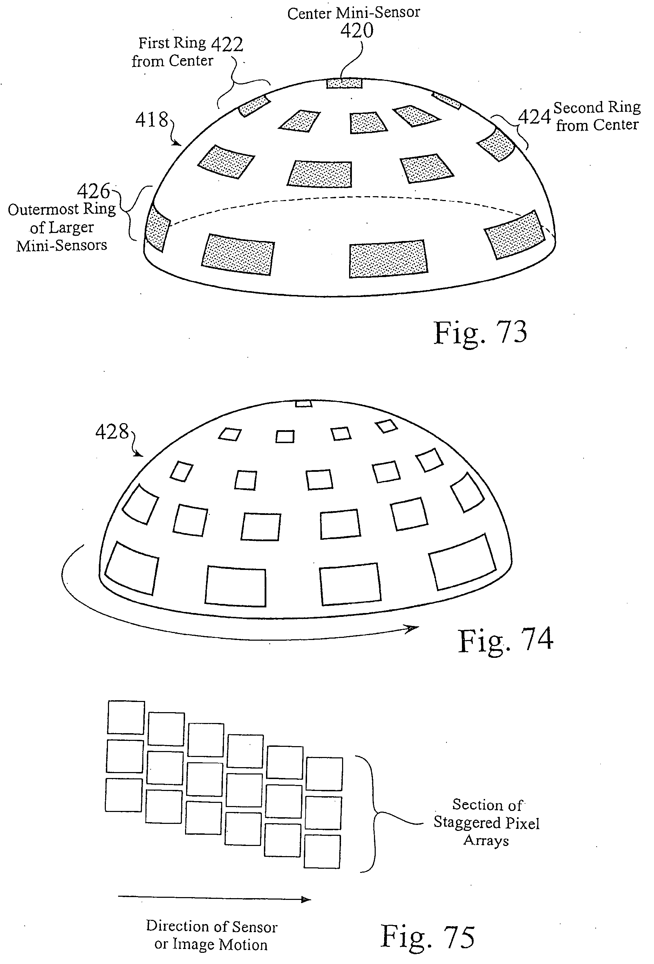

In the embodiment, the relatively "sparse" mini-sensors in the outermost ring are formed so that they are much larger than the other mini-sensors that are nearer to the center of the sensor, as shown in Figure 73. The relatively large mini-sensors are more sensitive than the smaller ones toward the center of the sensor. The mini-sensors in the center are relatively small, while mini-sensors in each successive larger ring are larger. Figure 73 shows a sensor 420 having a center mini-sensor 420, a first ring of mini-sensors 422, a second ring of mini-sensors 424, and an outermost ring of mini-sensors 426.

In yet another embodiment, this sensor may be generally constantly rotated, as shown in Figure 74. When the sensor rotates 0.001 degree, for example, which corresponds to roughly the same fraction of a pixel-to-image shift in all three rings; center, first surrounding ring and the outer ring. Multiple exposures can be used to capture more image detail than the pixel count would seem to suggest, since, the sensor is capturing new fractions of pixel images in subsequent exposures and edges. This method provides detail in a circular direction, but none added in the concentric direction.

Yet another embodiment is shown in Figure 75, which illustrates a section of staggered pixel arrays on a mini-sensor.

Although the present invention has been described in detail with reference to one or more preferred embodiments, persons of ordinary skill in the art will appreciate that various modifications and enhancements may be made.

### LIST OF REFERENCE CHARACTERS

- 10: Camera with curved sensor
- 12: Curved sensor
- 14: Enclosure
- 16: Objective lens
- 18: Incoming light
- 20: Electrical output from sensor
- 22: Signal processor
- 24: User controls
- 26: Battery
- 28: Memory
- 30: Camera output
- 32: Facet
- 34: Gap between facets
- 36: Via
- 38: Wiring backplane
- 40: Curved sensor formed from adjoining petal-shaped segments
- 42: Petal-shaped segment
- 43a: First Mandrel
- 43b: Substrate
- 43c: First sheet of deformable material
- 43d: Dome portion of deformable material over mandrel
- 43e: Hemispherical base for curved sensor
- 43f: Second sheet of deformable material
- 43g: Second mandrel
- 43h: Ports
- 43i: Empty region
- 43j: Heater
- 43k: Hemispherical base for curved sensor
- 44: Camera monitor
- 46: Conventional sensor with generally uniform pixel density
- 48: Sensor with higher pixel density toward center
- 50: Pixel
- 52: Shade retracted
- 54: Shade extended
- 56: Multi-lens camera assembly
- 58: Objective lens
- 60: Mirrored camera/lens combination
- 62: Primary objective lens
- 64: Secondary objective lens
- 66: First sensor
- 68: Second sensor
- 70: Mirror
- 72: Side-mounted sensor
- 74: Sensor in original position
- 76: Sensor in rotated position
- 78: Sensor in original position
- 80: Sensor in displaced position
- 82: Alternative embodiment of sensor
- 84: Alternative embodiment of sensor
- 86: Alternative embodiment of sensor
- 88: Alternative embodiment of sensor
- 90: View of rear of one embodiment of sensor
- 92: Spiral-shaped conductor
- 94: Connection to sensor
- 96: Connection to processor
- 98: View of rear of one embodiment of sensor
- 100: Accordion-shaped conductor
- 102: Connection to sensor
- 104: Connection to processor
- 106: View of rear of one embodiment of sensor
- 108: Radial conductor
- 110: Brush
- 112: Brush contact point
- 114: Annular ring
- 116: Center of sensor, connection point to processor
- 118: Schematic view of wireless connection
- 120: Transmitter
- 122: Receiver
- 124: Processor
- 150: Camera
- 154: Enclosure
- 156: Lens
- 160: Sensor
- 162: Facets
- 164: Gaps
- 170: Center square
- 172: Ring of squares
- 176: Ring of squares
- 180: Shade extender arrangement
- 182: Inner shade member
- 184: Movable shade member
- 186: Outer, movable shade members
- 190: Lens moving mechanism
- 200: Image sequence processor
- 202: Sensor capture device
- 204: Auto device
- 206: Pixel density normalization device
- 208: Image processing engine
- 210: Display/LCD controller
- 212: Compression and storage controller
- 250: Camera
- 256: Lens
- 260: Sensor
- 270: Central region facet
- 272: Surrounding region facets
- 274: Shutter control
- 280: Lens shade actuator
- 290: Focus/stabilization actuator
- 292: Lens moving
- 300: First embodiment of combined device
- 300a: First embodiment of combined device
- 300b: First embodiment of combined device
- 302: Housing
- 304: Micro-controller
- 305a: Front side
- 305b: Back side
- 306: Display screen
- 308a: Touch screen interface
- 308b: User interface
- 310: Terminal for power and/or data
- 314: Speaker
- 315: Antenna
- 330: View of alternative embodiment
- 334: View of alternative embodiment
- 338: View of alternative embodiment
- 340: View of alternative embodiment
- 342: Schematic illustration of moving lens with fixed flat sensor
- 344: Moving lens
- 346: Fixed flat sensor
- 348: Light path
- 350: Overhead view of Figure 51
- 352: Schematic illustration of moving lens with fixed curved sensor
- 354: Fixed curved sensor
- 356: Overhead view of Figure 53
- 358: Schematic illustration of fixed lens with moving flat sensor
- 360: Moving flat sensor
- 362: Fixed lens
- 364: Overhead view of Figure 55
- 365: Schematic depiction of components that impart circular motion to sensor
- 366: Spinning disc
- 367: Connecting post
- 368: Attachment point
- 370: Electric motor
- 372: Axis of motor
- 373: Perspective view of Figure 57
- 374: Schematic view of fixed lens over moving curved sensor
- 376: Moving curved sensor
- 377: Overhead view of Figure 59
- 378: Schematic illustration of components for imparting motion to lens
- 380: Band
- 382: Springs
- 384: Springs connected to cams
- 386: First cam
- 388: Second cam
- 390: First electric motor
- 392: Second electric motor
- 394: Series of nine views of rotating sensor
- 396: Sensor
- 398: Pixels
- 400: Optical fiber
- 402: Woven mesh of optical fibers
- 404: Heated first mandrel
- 405: Upper mandrel
- 406: Fabric dome
- 408: Trim excess fabric
- 410: Parallel fibers
- 412: Fused laminate
- 414: Two sets of fibers at right angles
- 418: Sensor with rows of mini-sensors of increasing size
- 420: Sensor
- 422: First ring of mini-sensors
- 424: Second ring of mini-sensors
- 426: Outermost ring of mini-sensors
- 428: Rotating sensor with rows of mini-sensors of increasing size
- 430: Sensor with rows of mini-sensors with every other mini-sensor shifted upwards

## Claims

1. A method for forming a curved sensor (418) comprising the steps of:
providing a curved sensor base (43e, k) having a vertical axis;
providing a plurality of flat mini-sensors (420, 422, 424, 426), each mini-sensor comprising a plurality of pixels of defined density; and
affixing said plurality of flat mini-sensors (420, 422, 424, 426) to said sensor base (43e, k) so that said flat mini-sensors are arranged in horizontal rows forming rings about the vertical axis,
wherein when starting from the center mini-sensor (420), each successive row is less densely populated with the pixels of the flat mini-sensors ( 422, 424, 426),
**characterized in that** the size of the center mini-sensor (420) is relatively small, while the mini-sensors (422, 424, 426) of each successive larger ring are larger.

2. A method as recited in claim 1, wherein the mini-sensors (420, 422, 424, 426) each have two side edges disposed to be parallel to an outer edge of said curved sensor base.

3. A method as recited in claim 1 or 2, wherein every other mini-sensor in each row of mini-sensors ( 422, 424, 426) is positioned slightly higher in vertical axis direction than its two neighboring mini-sensors in the same row.

4. A method as recited in claim 1, 2 or 3, wherein said curved sensor (418) is mounted so as to be continuously rotatable about its vertical axis.

## Patentansprüche

1. Verfahren zum Ausbilden eines gekrümmten Sensors (418), mit den folgenden Schritten:
Bereitstellen einer gekrümmten Sensorbasis (43e, k), die eine vertikale Achse hat;
Bereitstellen mehrerer flacher Minisensoren (420, 422, 424, 426), wobei jeder Minisensor mehrere Pixel definierter Dichte umfasst; und
Befestigen der mehreren flachen Minisensoren (420, 422, 424, 426) an der Sensorbasis (43e, k), so dass die flachen Minisensoren in horizontalen Reihen angeordnet sind, die Ringe um die vertikale Achse bilden,
wobei ausgehend vom zentralen Minisensor (420) jede nachfolgende Reihe weniger dicht mit den Pixeln der flachen Minisensoren (422, 424, 426) bestückt ist,
**dadurch gekennzeichnet, dass** die Größe des zentralen Minisensors (420) verhältnismäßig gering ist, während die Minisensoren (422, 424, 426) jedes nachfolgenden größeren Rings größer sind.

2. Verfahren nach Anspruch 1, wobei die Minisensoren (420, 422, 424, 426) jeweils zwei Seitenränder aufweisen, die so angeordnet sind, dass sie parallel zu einem Außenrand der gekrümmten Sensorbasis sind.

3. Verfahren nach Anspruch 1 oder 2, wobei jeder zweite Minisensor in jeder Reihe Minisensoren (422, 424, 426) in Richtung der vertikalen Achse geringfügig höher positioniert ist als seine beiden benachbarten Minisensoren in derselben Reihe.

4. Verfahren nach Anspruch 1, 2 oder 3, wobei der gekrümmte Sensor (418) so angebracht ist, dass er um seine vertikale Achse stufenlos verdrehbar ist.

## Revendications

1. Procédé de réalisation d'un capteur courbé (418), comportant les étapes suivantes :
prévision d'une base de capteur courbée (43e, k) qui présente un axe vertical,
prévision de plusieurs minicapteurs plats (420, 422, 424, 426), chaque minicapteur présentant une pluralité de pixels à densité définie, et
fixation des plusieurs minicapteurs plats (420, 422, 424, 426) sur la base de capteur (43e, k) de telle sorte que les minicapteurs plats sont agencés en rangées horizontales qui forment des anneaux autour de l'axe vertical,
dans lequel en partant du minicapteur central (420), chaque rangée suivante est équipée de manière moins dense des pixels des minicapteurs plats (422, 424, 426),
**caractérisé en ce que** la taille du minicapteur central (420) est relativement petite, tandis que les minicapteurs (422, 424, 426) de chaque anneau plus grand suivant sont plus grands.

2. Procédé selon la revendication 1, dans lequel les minicapteurs (420, 422, 424, 426) présentent chacun deux bords latéraux agencés de manière à être parallèles à un bord extérieur de la base de capteur courbée.

3. Procédé selon la revendication 1 ou 2, dans lequel un minicapteur sur deux dans chaque rangée de minicapteurs (422, 424, 426) est agencé légèrement plus haut dans le sens de l'axe vertical que ses deux minicapteurs adjacents dans la même rangée.

4. Procédé selon la revendication 1, 2 ou 3, dans lequel le capteur courbé (418) est monté de manière à être rotatif en continu autour de son axe vertical.
